(19) **Europäisches Patentamt European Patent Office Office européen des brevets**

(11) **EP 1 566 800 B1**

(12) **EUROPEAN PATENT SPECIFICATION**

(45) Date of publication and mention of the grant of the patent:
**26.03.2008 Bulletin 2008/13**

(51) Int Cl.:
***G11B 7/24*** (2006.01)

(21) Application number: **05011264.8**

(22) Date of filing: **04.06.2003**

(54) **Optical recording medium, process for manufacturing the same, and optical recording process using the same**

Optisches Aufzeichnungsmedium, Herstellungsprozess für dasselbe, Sputtertarget zur Herstellung desselben und optisches Aufzeichnungsverfahren für dasselbe

Support d'enregistrement optique, procédé de fabrication du même, cible de pulverisation cathodique pour le procédé de fabrication du même et procédé d'enregistrement utilisant le même

(84) Designated Contracting States:
**DE ES FR GB IT NL**

(30) Priority: **05.06.2002 JP 2002163793**
**28.06.2002 JP 2002189628**
**08.07.2002 JP 2002198114**
**23.07.2002 JP 2002214500**
**04.09.2002 JP 2002258638**
**27.11.2002 JP 2002344719**

(43) Date of publication of application:
**24.08.2005 Bulletin 2005/34**

(62) Document number(s) of the earlier application(s) in accordance with Art. 76 EPC:
**03012695.7 / 1 372 148**

(73) Proprietor: **Ricoh Company, Ltd.**
**Tokyo 143-8555 (JP)**

(72) Inventors:
• **Harigaya, Makoto,**
**c/o Ricoh Company Ltd.**
**Tokyo 143-8555 (JP)**
• **Ito, Kazunori,**
**c/o Ricoh Company Ltd.**
**Tokyo 143-8555 (JP)**
• **Tashiro, Hiroko,**
**c/o Ricoh Company Ltd.**
**Tokyo 143-8555 (JP)**
• **Mizutani, Miku**
**Kumagaya-shi**
**Saitama (JP)**
• **Shinotsuka, Michiaki,**
**c/o Ricoh Company Ltd.**
**Tokyo 143-8555 (JP)**
• **Iwasa, Hiroyuki,**
**c/o Ricoh Company Ltd.**
**Tokyo 143-8555 (JP)**
• **Shinkai, Masaru,**
**c/o Ricoh Company Ltd.**
**Tokyo 143-8555 (JP)**

(74) Representative: **Barz, Peter**
**Patentanwalt**
**Kaiserplatz 2**
**80803 München (DE)**

(56) References cited:
**EP-A- 1 260 973         WO-A-02/084657**
**US-A- 5 848 043**

**EP 1 566 800 B1**

**Description**

BACKGROUND OF THE INVENTION

Field of the Invention

The present invention relates to a phase change optical recording medium on which materials to be recorded are optically changed by irradiating electromagnetic wave, and which enables recording and reproducing and rewriting.

Description of the Related Art

As one of optical recording media which enables recording and reproducing and erasing by irradiating a light, there is known a so-called phase change optical disk. Such phase change optical disk utilizes a phase transition between a crystalline phase and an amorphous phase, or between a crystalline phase and other crystalline phase. Since overwriting on the phase change optical disk can be carried out by a single beam, and because of the simple optical system of driving, such optical disk is generally employed as AV-related recording media or as recording media for a computer.

Materials used for the recording media include Ge-Te, Ge-Te-Se, In-Sb, Ga-Sb, Ge-Sb-Te, and Ag-In-Sb-Te. In particular, Ag-In-Sb-Te is employed as a mark edge recording material, having features such as high sensitivity, and clear outline of amorphous part in a recording mark (see Japanese Patent Application Laid-Open (JP-A) No. 03-231889, JP-A No. 04-191089, JP-A No. 04-232779, JP-A No. 04-267192, and JP-A No. 05-345478, or the like).

However, these recording materials are to be used for an optical recording medium having relatively low recording density, such as CD-RW (Compact Disk-Rewritable). If it is used in DVD (Digital Versatile Disk) RAM or DVD-RW and the like, overwriting can be carried out when a recording linear velocity is around 3.5m/s ($\times$ 1 speed). However, when it becomes $\times$ 2 speed or faster, there is a problem that overwriting property may deteriorate. It is because speed for crystallization of the recording materials as described above is low, thus overwriting in high linear velocity becomes difficult.

It is possible to crystallize faster, by increasing the amount of Sb, but this may lead to fall in crystallization temperature due to increase of Sb, and then a storage property may be deteriorated.

To solve this problem, there is disclosed an approach to use Ag-In-Ge-Sb-Te system recording material in JP-A No. 2000-322740. It is possible to apply this approach when the recording linear velocity is 3.0 m/ s to 20 m/ s, but at a higher velocity, such as 20 m/s or more, it is not applicable.

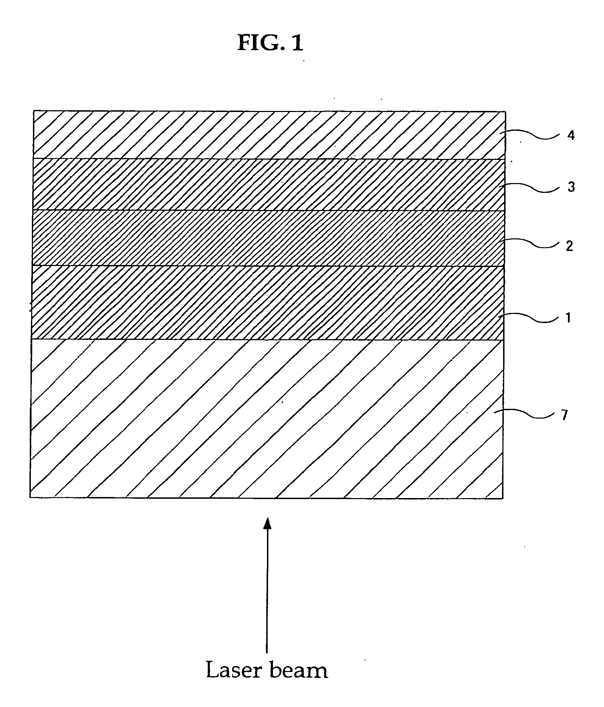

In the meantime, GaSb has been proposed as a high-speed crystallization material ("Phase-change optical data storage in GaSb" Applied optics. /vol. 26, No. 22115, November 1987). It is reported that as for this alloy, crystallization speed is extremely high, however, since a crystallization temperature is as high as 350°C, crystallization at the initial stage is difficult. Furthermore, the U.S. Patent Nos. 4,818,666 and 5,072,423 disclose that Mo, W, Ta, Ni, Pd, Pt, Cu, Ag, Au, Zn, Cd, Al, Tl, Si, Ge, Sn, Pb, As, Bi, S, Se, Te or the like are added to GaSb, so as to enhance its property. However, such disclosures do not satisfy an overwriting property at high speed recording, degree of modulation and archival stability at the same time. For instance, the optical recording medium disclosed in the U.S. Patent No. 4,818,666 utilizes the phase change between the crystalline and crystalline phases for optical recording. The modulation is 0.29 at the best, which causes problems in the practical use. The U.S. Patent No. 4,818,666 states that a layer or a film lifts up, which is presumably because of the bubble generated on a portion where a laser beam is irradiated, when a content of Ga is less than 20%. It also states that, because of the lift-up, the level, in which the reflectance differs, becomes unstable. The U.S. Patent No.4,818,666 states that the invention stated therein causes problems in practical use, accordingly. The phase change between the crystal and crystalline phases utilizes the difference in reflectance derived from the difference in the crystal particle diameters. Therefore, it is unfavorable for the high-density recording that requires fine marks. The optical recording medium disclosed in the U.S. Patent No.4,818,666 does not allow the same recording capacity as DVD-ROM. Appl. Phys. Lett. 60 (25), 22 June 1992, pp.3123-3125 states an optical recording medium that utilizes a GeSb thin film and that is capable of phase change at an extra-high speed. An electron diffraction shown in the FIG. 1 attached thereto does not describe the orientation of crystals. Furthermore, the modulation between a phase which serves as the crystalline phase and the amorphous phase is 0.15 to 0.2, which causes problems in practical use.

Japanese Patent Application Laid-Open (JP-A) No. 2001-39031 discloses an optical recording medium whose recording layer is mainly formed of alloy as $(Sb_xGe_{1-x})_{1-y}In_y$ (herein, $0.65 \leq x \leq 0.95$, $0 \leq y \leq 0.2$). However, there is only one statement in initialization condition of the optical recording medium. It only states that the initialization condition is to crystallize at an initial phase with a laser power density of around 2.6mW/$\mu$m2. There is no statement about a high laser power density at an initial phase. The low laser power density as disclosed therein provides a medium having poorly oriented crystals and low reflectance. The recording linear velocity disclosed therein is as slow as 2.4m/ s to 9.6m/s, which does not meet the present invention's a high recording linear velocity.

EP-A-1260973 discloses an optical recording medium having a recording layer which comprises a phase-

**2**

change recording material causing a reversible phase change between a crystalline phase and an amorphous phase by irradiation with an electromagnetic wave, wherein the phase-change recording material mainly comprises a material expressed by the formula: $X_\alpha Ge_\beta Mn_\gamma Sb_\delta Te_\varepsilon$, wherein X expresses at least one of Ga and Sn and $\alpha$, $\beta$, $\gamma$, $\delta$ and $\varepsilon$ are atomic percentages satisfying the following relations: $0 \leqq \alpha \leqq 5, 1 \leqq \beta \leqq 5, 1 \leqq \gamma \leqq 10, 65 \leqq \delta < 80, 15 \leqq \varepsilon \leqq 25$, $\alpha \leqq \gamma$, and $\alpha + \beta + \gamma + \delta + \varepsilon = 100$.

As described above, various kinds of phase change recording materials have been reported so far, but any of the materials has not been satisfactorily provided with the properties required by a rewritable phase change optical recoding medium. In particular, those have not been the materials such as having a high-density recording capacity equivalent of that of DVD-ROM's, being capable of handling a situation when recording linear velocity is further increased (- 35 m/S), and simultaneously satisfying requirements as to overwriting property, degree of modulation, and archival stability.

SUMMARY OF THE INVENTION

The present invention has been proposed in view of the problems of the related arts as mentioned above.

It is therefore an object of the present invention to provide an optical recording medium which is capable of recording and erasing by a reversible phase change between an amorphous phase and a crystalline phase in the recording layer, and has a large degree of modulation and good stability in an amorphous mark. The optical recording medium is capable of recording and erasing by a reversible phase change between an amorphous phase and a crystalline phase, even at a high linear velocity of 10m/s or more.

In order to solve the above problems, the inventors of the present invention have focused attention on materials in recording layer, and have dedicated to and pursued their studies, resulting in accomplishment of the present invention. The above problems can be solved by the following aspects of the present invention.

According to a first aspect of the present invention, the present invention provides an optical recording medium as claimed in claim 1 which comprises a substrate and a recording layer disposed on the substrate, recording and erasing being carried out by a reversible phase change between an amorphous phase and a crystalline phase in the recording layer,

wherein the recording layer contains Ga and Sb, the content of Sb being 80 atom% to 95 atom% relative to the total content of Ga and Sb in the recording layer, and

wherein the recording layer further contains either (1) Bi and Rh or (2) Zr and Mg as additional elements.

According to a second aspect of the present invention, the recording layer containing Ga, Sb, Bi and Rh further contains one element selected from Cu, B, N, Ge, Fe and Ir.

According to a third aspect of the present invention, the recording layer containing Ga, Sb, Zr and Mg further contains one element selected from Al, C, N, Se and Sn.

According to a fourth aspect of the present invention, the total content of the Ga and the Sb is 90atm% or more in the recording layer.

According to a fifth aspect of the present invention, the total content of the Ga and the Sb in the recording layer is 95atm% or more.

According to a sixth aspect of the present invention, the content of the Sb is 85atm% to 95atm% relative to the total content of the Ga and the Sb in the recording layer.

According to a seventh aspect of the present invention, the optical recording medium comprises the substrate, a first protective layer, the recording layer, a second protective layer, and a reflection layer. In the optical recording medium of the seventh aspect, the first protective layer, the recording layer, the second protective layer, and the reflection layer are disposed on the substrate in this order, and a thickness of the reflection layer satisfies a relation of: $0.10\lambda$ or more, when the "$\lambda$" expresses the wavelength of the laser beam.

According to an eighth aspect of the present invention, the laser beam may have the wavelength of 630nm to 700nm.

According to a ninth aspect of the present invention, the optical recording medium comprises the substrate, a first protective layer, the recording layer, a second protective layer, and a reflection layer. In the optical recording medium of the ninth aspect, the first protective layer, the recording layer, the second protective layer, and the reflection layer are disposed on the substrate in this order, and each of a thickness of the first protective layer, a thickness of the recording layer, a thickness of the second protective layer, and a thickness of the reflection layer satisfies the following relations, when "$\lambda$" expresses the wavelength of the laser beam;

$$0.070\lambda \leq t_1 \leq 0.16\lambda$$

$$0.015\lambda \le t_2 \le 0.032\lambda$$

$$0.011\lambda \le t_3 \le 0.040\lambda$$

$$0.\,10\lambda \le t_4\,;$$

wherein "$t_1$" expresses the thickness of the first protective layer, "$t_2$" expresses the thickness of the recording layer, "$t_3$" expresses the thickness of the second protective layer, and "$t_4$" expresses the thickness of the reflection layer.

According to a tenth aspect of the present invention, the thickness of the recording layer may be 5nm to 25nm.

According to an eleventh aspect of the present invention, the thickness of the recording layer may be 8nm to 20nm.

According to a twelfth aspect of the present invention, the laser beam may have wavelength of 350nm to 450nm.

According to a thirteenth aspect of the present invention, the optical recording medium comprises the substrate, a first protective layer, the recording layer, a second protective layer, and a reflection layer. In the optical recording medium of the thirteenth aspect, the first protective layer, the recording layer, the second protective layer, and the reflection layer are disposed on the substrate in this order, and each of a thickness of the first protective layer, a thickness of the recording layer, a thickness of the second protective layer, and a thickness of the reflection layer satisfies the following relations, when "$\lambda$" expresses the wavelength of the laser beam;

$$0.070\lambda \le t_1 \le 0.5\lambda$$

$$0.015\lambda \le t_2 \le 0.05\lambda$$

$$0.011\lambda \le t_3 \le 0.055\lambda$$

$$0.\,10\lambda \le t_4\,;$$

wherein "$t_1$" expresses the thickness of the first protective layer, "$t_2$" expresses the thickness of the recording layer, "$t_3$" expresses the thickness of the second protective layer, and "$t_4$" expresses the thickness of the reflection layer.

According to a fourteenth aspect of the present invention, the optical recording medium comprises the substrate, a reflection layer, a second protective layer, the recording layer, a first protective layer, and a light transmittance layer. In the optical recording medium of the fourteenth aspect, the reflection layer, the second protective layer, the recording layer, the first protective layer, and the light transmittance layer are disposed on the substrate in this order, and each of a thickness of the reflection layer, a thickness of the second protective layer, a thickness of the recording layer, and a thickness of the first protective layer, and a thickness of the light transmittance layer satisfies the following relations, when "$\lambda$" expresses the wavelength of the laser beam;

$$0.10\lambda \le t_4 \le 0.75\lambda$$

$$0.011\lambda \le t_3 \le 0.055\lambda$$

$$0.015\lambda \le t_2 \le 0.05\lambda$$

$$0.070\lambda \le t_1 \le 0.5\lambda$$

$$0 \le t_5 \le 0.6\text{mm},$$

wherein "$t_4$" expresses the thickness of the reflection layer, "$t_3$" expresses the thickness of the second protective layer, "$t_2$" expresses the thickness of the recording layer, "$t_1$" expresses the thickness of the first protective layer, and "$t_5$" expresses the thickness of the light transmittance layer.

According to a fifteenth aspect of the present invention, the optical recording medium may further comprises one or more of the recording layers.

According to a sixteenth aspect of the present invention, the optical recording medium includes a first information layer which has one of the recording layers, and a second information layer which has other one of the recording layers in this order, from a direction that the laser beam is irradiated, and a light transmittance of the first information layer is 40% or more with the wavelength.

According to a seventeenth aspect of the present invention, the recording and the erasing are carried out by the reversible phase change between the amorphous phase and the crystalline phase in the recording layer, at a linear velocity of 14m/s or more.

According to an eighteenth aspect of the present invention, the recording and the erasing are carried out by the reversible phase change between the amorphous phase and the crystalline phase in the recording layer, at a linear velocity of 28m/s or more.

According to a nineteenth aspect of the present invention, a reflectance (Rg) at an unrecorded space part satisfies a relation of 12% ≤ Rg ≤30%, when a laser beam having wavelength between 350nm and 700nm is irradiated.

According to a twentieth aspect of the present invention, the optical recording medium has a degree of modulation (M) of 0.4 or more, when the recording is carried out at a linear velocity (V) one of between more than 3m/ s and 40m/ s or less and at wavelength of a laser beam of between 350nm and 700nm, and the degree of modulation (M) satisfies a relation of:

$$M = (Rg-Rb)/Rg,$$

where "M" expresses the degree of modulation, "Rb" expresses a reflectance at a recording mark of the optical recording medium, and "Rg" expresses a reflectance at an unrecorded space part of the optical recording medium.

According to a twenty first aspect of the present invention, the optical recording medium has the degree of modulation (M) of 0.4 or more, when the recording is carried out by an optical lens having NA of 0.60 or more.

According to a twenty second aspect of the present invention, the optical recording medium has the degree of modulation (M) of 0.6 or more.

According to a twenty third aspect of the present invention, the optical recording medium has the degree of modulation (M) of 0.4 or more, when the recording is carried out at any linear velocity (V) between 10m/ s and 35m/ s.

According to a twenty fourth aspect of the present invention; the optical recording medium has the degree of modulation (M) of 0.6 or more, when the recording is carried out at any linear velocity (V) between 10m/s and 35m/ s.

According to a twenty fifth aspect of the present invention, the optical recording medium comprises the substrate, a first protective layer, the recording layer, a second protective layer, a reflection layer, and a surrounding protective layer. In the optical recording medium of the thirty third aspect, the first protective layer, the recording layer, the second protective layer, and the reflection layer are disposed on the substrate in this order, and the surrounding protective layer is disposed on a surface of the reflection layer.

According to a twenty sixth aspect of the present invention, the present invention provides a process for manufacturing an optical recording medium which comprises the steps of: disposing a first protective layer, a recording layer, a second protective layer, a reflection layer in this order on a substrate, so as to manufacture an optical recording medium prior to initial crystallization; and irradiating a laser beam having a power density of 5mW/$\mu$m$^2$ to 50mW/$\mu$m$^2$ to the optical recording medium prior to initial crystallization, while rotating the optical recording medium prior to initial crystallization and radially moving the laser beam at a constant linear velocity for initial crystallization of 3m/ s to 18m/s, so as to initially crystallize the optical recording medium prior to initial crystallization and manufacture the optical recording medium of the present invention.

According to a twenty seventh aspect of the present invention, the laser beam has the power density of 15mW/$\mu$m$^2$ to 40mW/$\mu$m$^2$, and the constant linear velocity for initial crystallization is 6m/s to 14m/s. the laser beam has the power density of 15mW/$\mu$m$^2$ to 40mW/$\mu$m$^2$, and the constant linear velocity for initial crystallization is 6m/s to 14m/s.

According to a twenty eighth aspect of the present invention, the present invention provides an optical recording process which comprises the steps of: forming a laser beam which reversibly phase changes between an amorphous phase and a crystalline phase in a recording layer which is disposed on a substrate of the optical recording medium of the present invention, so as to have one of a single pulse and a plurality of pulses; and irradiating the laser beam to the optical recording medium at a linear velocity (V) one of between more than 3m/s and 40m/s or less, and at a recording power (Pw) having a power density of 20mW/$\mu$m$^2$ or more, so as to record in the recording layer.

According to a twenty nineth aspect of the present invention, the linear velocity (V) is one of between 10m/s and 35m/s.

According to a thirtieth aspect of the present invention, the laser beam is irradiated, so that a ratio of an erasing power (Pe) to the recording power (Pw) satisfies a relation of:

$$0.10 \le Pe/Pw \le 0.65,$$

where "Pe" expresses the erasing power and "Pw" expresses the recording power.

According to a thirty first aspect of the present invention, the laser beam is irradiated so as to have a ratio of an erasing power (Pe) to the recording power (Pw) which satisfies a relation of:

$$0.13 \le Pe/Pw \le 0.6,$$

where "Pe" expresses the erasing power and "Pw" expresses the recording power.

BRIEF DESCRIPTION OF THE DRAWINGS

FIG.1 is a sectional view showing an example of a schematic structure of an optical recording medium according to the present invention.

FIG. 2 is a sectional view showing another example of a schematic structure of an optical recording medium according to the present invention.

FIG. 3 is a sectional view showing an example of a schematic structure of an optical recording medium having two recording layers.

FIG. 4 is a perspective view showing an example of a schematic structure of an optical recording medium according to the present invention.

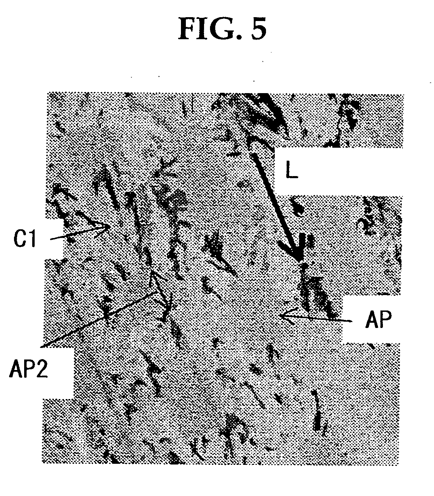

FIG. 5 is a transmission electronographic image showing an example of a recording layer after an initial recording.

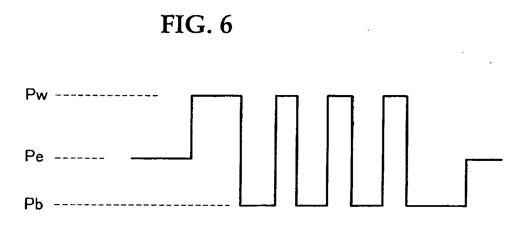

FIG. 6 is a view showing a recording strategy which is generally used for a rewritable optical recording medium.

DESCRIPTION OF THE PREFERRED EMBODIMENTS

Referring to the accompanying drawings, the embodiments of the present invention will be described hereinafter.

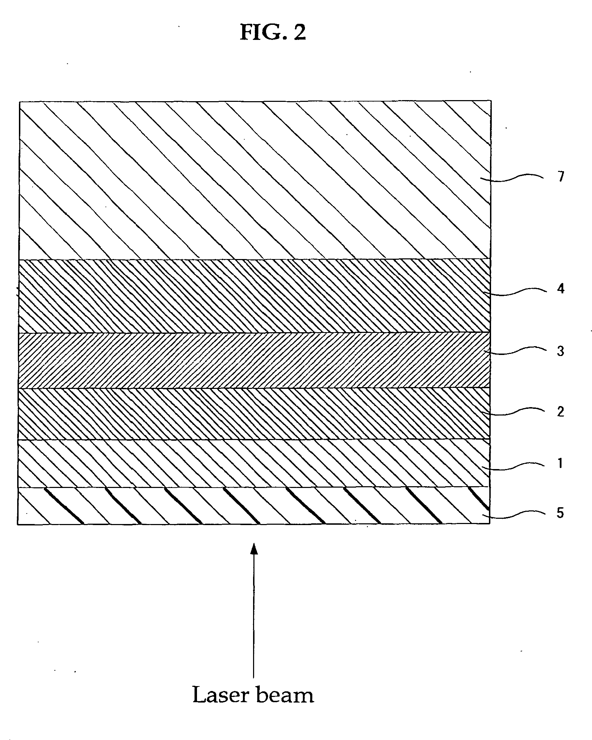

FIG. 1 and FIG. 2 are each sectional views showing examples of schematic structures of an optical recording medium according to the present invention. FIG. 1 shows a structure where a first protective layer 1, a recording layer 2, a second protective layer 3 and a reflection layer 4 are sequentially disposed on a substrate 7. Protective layer such as the first protective layer 1 and the second protective layer 3, are not required to be disposed. However, when the substrate 7 comprises a material having poor heat resistance such as a polycarbonate resin, the first protective layer is preferably disposed. A surrounding protective layer can also be disposed if necessary, though not shown in the figures.

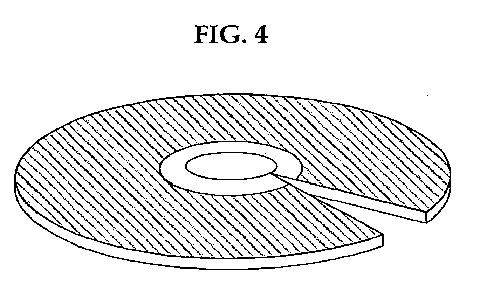

FIG. 2 shows an example of a structure where the reflection layer 4, the second protective layer 3, the recording layer 2, and the first protective layer 1 are sequentially disposed on the substrate 7, in the inverse order of the structure in FIG. 1. In the structure shown in FIG. 2, a light transmittance layer 5 is additionally disposed. Each of the optical recording media is subjected to recording and reproducing by irradiating a laser beam from the direction shown in FIGs. 1 and 2. An optical recording medium having the structure of FIG. 2 has a suitable structure for making the spot diameter of the laser beam smaller by enhancing numerical aperture (NA) of objective lens of an optical pickup, thereby allowing the recording mark to have higher density. The optical recording medium of the present invention preferably has a disk-shape. FIG. 4 is a perspective view showing an example of a schematic structure of an optical recording medium according to the present invention. A sectional view of a cut portion of the optical recording medium shown in FIG. 4 can be referred to as the one shown in FIG. 1, for example. Here, it should be noted that the optical recording medium of the present invention is not limited to the above configurations.

Hereinafter, the present invention will be described in detail.

As for material in a recording layer of the recent DVD system, there is already a marketed DVD system capable of recording at the speed of 2.5X (around 8.5 m/s recording linear velocity). Further demand has been made on a higher speed recording.

In view of this situation, the inventors of the present invention have researched and developed a recording material for an optical recording medium, which is capable of high density recording in a capacity equivalent to, or more than that of DVD-ROM, and which covers, at the same time, $\times$ 10 speed of recording (around 35 m/s or more). As a result, it has been found out that a preferable composition is the one closer to an eutectic composition of Ga and Sb.

It appears that the material, Ga and Sb, was proposed in development of a rewritable optical disk having reflectance interchangeability with CD-ROM in the middle of the 1980's. However, a low reflecting medium formed of AgInSbTe was alternatively proposed, and thus the Ga and Sb did not appear in the practical use.

The inventors of the present invention has found out that an optical recording medium is capable of recording and erasing by a reversible phase change between an amorphous phase and a crystalline phase by comprising a substrate and a recording layer disposed on the substrate in which the recording layer comprises Ga and Sb, and a content of the Sb is 80atom% to 95atom% relative to a total content of the Ga and the Sb in the recording layer. The optical recording medium having a composition ratio of the above is capable of recording at a high linear velocity, and of being applied to a wide range of the linear velocity at recording.

In the recording layer, a content of Sb is 80atom% to 95atom% relative to a total content of Ga and Sb. The content of Sb is preferable from a viewpoint of obtaining an optical recording medium having a good C/N ratio. The total content of Ga and Sb in the recording layer is preferably 90 atom % or more, and more preferably 95atom% or more.

The optical recording medium of the present invention is capable of recording and erasing by a reversible phase change between an amorphous phase and a crystalline phase, preferably at a linear velocity of 10m/s or more, more preferably at a linear velocity of 14m/ s or more, and still more preferably at a linear velocity of 28m/s or more. Here, the optical recording medium of this aspect refers to the one that has a capability of recording and erasing at a linear velocity of 10m/s or more. The optical recording medium of this aspect may be or may not be capable of recording and erasing at a linear velocity of less than 10m/s.

However, the inventors of the present invention have confirmed the following. As described above, a limit of a recording linear velocity of the optical recording medium formed of AgInSbTe is around 20 m/s. As for Ga Sb, it has been confirmed by an experiment that a sufficient degree of modulation can be obtained, at a linear velocity up to around 35 m/ s even with the Ga and Sb alone, when recording is carried out under a condition of 12% < Rg ≤ 30%, preferably 20% ≤ Rg ≤ 30% (herein "Rg" expresses a reflectance at an unrecorded space part of a disk upon irradiating a laser beam having wavelength of between 350nm to 700nm), using a DVD recording system having lens NA of around 0.65. The optical recording medium thus manufactured maintains good jitter properties even upon repetitive overwriting, and has very few problems regarding archival stability.

In order to satisfy such conditions, the optical recording medium comprises a substrate, a first protective layer, a recording layer, a second protective layer, and a reflection layer. In the optical recording medium, the first protective layer, the recording layer, the second protective layer, and the reflection layer are disposed on the substrate in this order. A thickness of the reflection layer preferably satisfies a relation of "0.10λ or more," when the "λ" expresses wavelength of the laser beam.

When the wavelength of the laser beam is 630nm to 700nm, a thickness of the second protective layer and a thickness of the reflection layer each satisfy the following relations, and a thickness of the recording layer and a thickness of the first protective layer can mainly be adjusted.

$$0.011\lambda \leq t_3 \leq 0.040\lambda$$

$$0.10\lambda \le t_4;$$

wherein "$t_3$" expresses the thickness of the second protective layer, and "$t_4$" expresses the thickness of the reflection layer. In particular, when the wavelength is determined, since the thicknesses of the recording layer and the protective layer are selected from an extremely limited range, it is easy to determine these thicknesses of the recording layer and the first protective layer.

The high reflectance within the "Rg," can be attained by thickening the recording layer and the first protective layer. Furthermore, in order to control the reflectance by the first protective layer within the range defined by the above relations of "Rg," the thickness of the recording layer preferably satisfies a relation of:

$$0.015\lambda \le t_2 \le 0.032\lambda,$$

wherein the "$t_2$" expresses the thickness of the recording layer.

The thickness of the first protective layer preferably satisfies a relation of:

$$0.070\lambda \le t_1 \le 0.16\lambda,$$

wherein the "$t_1$" expresses the thickness of the first protective layer.

If the thickness of the recording layer is within the range defined by the above relations, the thickness of the first protective layer may become larger than the thickness defined by the above relations. In the other words, the thickness of the first protective layer may satisfy other relations than the above in which the thicknesses are larger than the above relations.

If the thickness of the first protective layer satisfies the other relations than the above, it takes more time to form and dispose the first protective layer.

Therefore, from a viewpoint of manufacturing an optical disk (an optical recording medium), the thickness of the first protective layer is preferably within the range defined by the above relation, in order to produce at low-cost. Therefore, the thickness of the first protective layer preferably satisfies the relation of:

$$0.070\lambda \le t_1 \le 0.16\lambda,$$

wherein the "$t_1$" expresses the thickness of the first protective layer.

Since the reflectance changes an absorption factor of light energy in a disk (an optical recording medium), it is an important property that influences recording properties of a disk. That is, when "Rg" is more than 30%, recording energy shorts, and a sufficient degree of modulation cannot be obtained. On the other hand, when the "Rg" is less than 12%, sufficient signal strength, which is necessary for a recording system, cannot be obtained.

The second protective layer plays a role of efficiently transmitting the light energy to the reflection layer and the light energy having been absorbed in the disk (the light energy is mainly absorbed in a recording layer material), so as to dissipate the heat derived from the light energy. If the second protective layer is too thick, heat is kept inside and a recording mark becomes fuzzy or unclear. The recording property, particularly jitter property hence deteriorates. If the second protective layer is too thin, heat is released to the reflection layer before reaching a heat amount required to exhibit a phase change recording principle in which the light energy absorbed in the recording layer accumulates therein and the recording layer melts to produce a recording mark. Therefore, sufficient recording property may not be obtained. It is preferable that the second protective layer is not very thick, and is within a range defined by the above relation.

In addition, it is necessary to change the thickness of the second protective layer, since power density of a laser beam changes according to wavelength to be used in a recording system. This problem can be solved by placing the thickness within a range that satisfies the above relation. This can be applied to the thicknesses of the other layers.

Here, the jitter property is evaluated by mark-edge dispersion, o/Tw, with respect to a channel cycle, "Tw."

The reflection layer plays a role of releasing the light energy, which has been absorbed in the disk (absorption is mainly carried out by a recording layer material), and also plays a role of reflecting the incident light of the light energy in an optical disk. If the thickness of the reflection layer satisfies a certain level, both of the roles can be carried out.

The inventors of the present invention have found out, through the experiments, that a preferable thickness of the reflection layer is around 60nm or more in order to attain the roles. The maximum thickness of the reflection layer is not particularly limited, as long as the thickness does not affect the manufacturing cost of the disk. The preferable thickness is considered to be 300nm or less.

When using the laser beam for recording, the thickness of the first protective layer is preferably 40nm or more, from a viewpoint of protecting the substrate from heat, and the thickness of the first protective layer is preferably 500nm or less, from a viewpoint that separation is less likely to occur between the substrate and a surface of the first protective layer.

The thickness of the first protective layer enables controlling a degree of modulation (M). In an optical recording medium comprising Ga and Sb according to the present invention, when a recording and reproducing system for a optical recording medium is utilized, there may be a case that a degree of modulation is small.

The degree of modulation (M), can be obtained by the following equation, when a recording test is carried out in an evaluation system of NA 0.65 and wavelength of 660nm, as currently used in a DVD for recording:

$$M = (IH - IL) / IH,$$

wherein "M" expresses the degree of modulation, "IH" expresses a signal level of a space part having a maximum mark length, and "IL" expresses a signal level of a space part having a maximum space length.

In the above condition, the degree of modulation (M) in the currently used optical disk system is required to be around 0.5 or more. On the other hand, if the aforementioned thickness of each of the layers is large, in particular, if the thickness of the first protective layer is large, the degree of modulation may become less than 0.4.

Note that "the reflectance at unrecorded space part, 'Rg,' " has the same meaning as the signal level of a space part having a maximum mark length, "IH," (a signal level when the laser beam was irradiated 100%, is considered as 200%). It also should be noted that "the reflectance at recording mark (recorded portion), 'Rb,'" has the same meaning as the signal level of a space part having a maximum space length, "IL."

The necessary degree of modulation when irradiating a laser beam having wavelength of 630nm to 700nm may be attained, and determining the thickness of the first protective layer so as to have the degree of modulation of 0.4 or more when irradiating the laser beam having the above-mentioned wavelength, and also by controlling the thicknesses of the first protective layer and the recording layer.

In order to have smaller recording marks and to have smaller intervals between the recording marks for achieving higher capacity of the optical recording medium, the wavelength of the laser beam is required to be short. The optical recording medium of the present invention realizes a higher capacity at the same time as having shorter wavelength of the laser beam. The optical recording medium of the present invention can be used when irradiating a laser beam having any wavelength of between 350nm to 450nm.

When irradiating a laser beam having wavelength of between 350nm to 450nm, the thicknesses of each of the layers of the optical recording medium shown in FIG. 1 and FIG. 2, preferably satisfy the following relations, when "$\lambda$" expresses wavelength of the laser beam to be irradiated.

Referring into FIG. 1 and FIG. 2, the thickness of the recording layer 2, "$t_2$," preferably satisfies a relation of " $0.015\lambda \leq t_2 \leq 0.05\lambda$." If the "$t_2$" is $0.015\lambda$ or more, it is preferable from a viewpoint of having a uniform thickness. If the " $t_2$" is $0.05\lambda$ or less, it is preferable from a viewpoint of recording sensitivity.

The thickness of the first protective layer 1, "$t_1$" preferably satisfies a relation of "$0.070 \lambda \leq t_1 \leq 0.5\lambda$" If the "$t_1$" is $0.070 \lambda$ or more, it is preferable from a viewpoint of protecting the substrate from heat generated upon recording. If the "$t_1$" is $0.5 \lambda$ or less, it is preferable from a viewpoint of mass-production. The thicknesses, "$t_2$" and "$t_1$," are controlled or adjusted within the relations above, so as to have the most suitable reflectance when a laser beam is irradiated.

The thickness of the second protective layer 3, "$t_3$," satisfies a relation of "$0.011\lambda \leq t_3 \leq 0.0557 \lambda$." If the "$t_3$" is $0.0111\lambda$ or more, it is preferable from a viewpoint of recording sensitivity. If the "$t_3$" is $0.055 \lambda$ or more, it is preferable from a viewpoint that microscopic plastic deformation is accumulated inside the second protective layer 3, in accordance with repetitive overwriting and thus prevents an increasing noise level.

The thickness of the reflection layer 4, "$t_4$," preferably satisfies a relation of "$0.10 \lambda \leq, t_4$." The "$t_4$" is preferably $0.10\lambda$ or more, from a viewpoint of repetitive recording property. As shown in FIG. 2, if the reflection layer 4 is adjacent to the substrate 7, the thickness of the reflection layer 4, "$t_4$," satisfies a relation of "$0.10\lambda \leq t_4 \leq 0.75\lambda$." If the "$t_4$" is larger than $0.75\lambda$, a shape of the recording layer 2 may become largely different from the groove of the substrate, and a problem such as crack may occur.

In the structure of FIG. 2, the thickness of the light transmittance layer 5 which is formed on the uppermost in the structure, "$t_5$," is preferably as thin as possible. For instance, "$t_5$" satisfies a relation of "$0 \leq t_5 \leq 0.6$ mm," so as to make a tilt margin larger, even when numerical aperture (NA) of an objective lens used for forming laser spot is large.

If the "$t_5$" is larger than 0.6 mm, aberration may occur, causing an increase in errors.

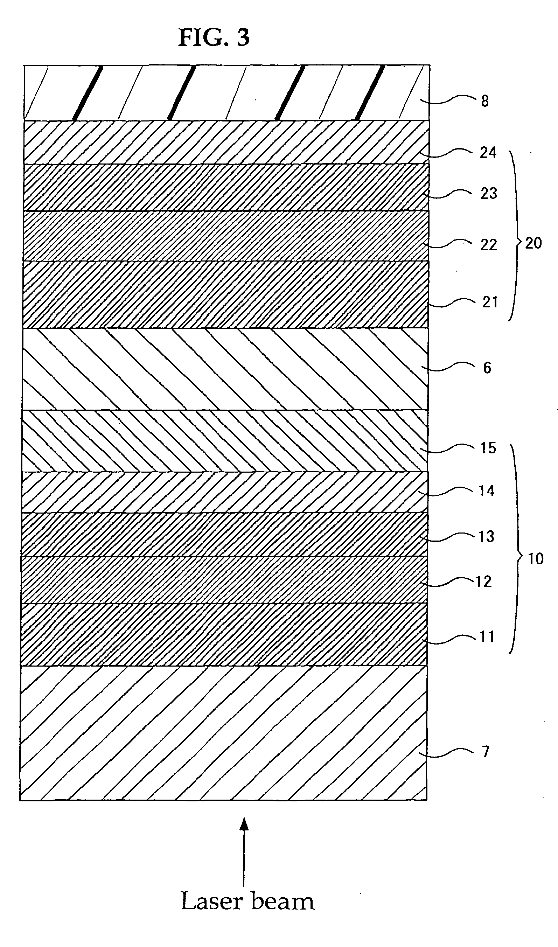

Furthermore, the optical recording medium of the present invention may have a multi-layer structure which has a high recording density, by providing two or more of the recording layers. FIG. 3 is a sectional view showing an example of a schematic structure of the optical recording medium having two of the recording layers. A first information layer 10, and a second information layer 20 are disposed in this order on the substrate 7. An intermediate layer 6 is disposed between the first information layer 10 and the second information layer 20. The first information layer 10 includes the first protective layer 11, the recording layer 12, the second protective layer 13, and the reflection layer 14. The second information layer 20 includes the first protective layer 21, the recording layer 22, the second protective layer 23, and the reflection layer 24. A heat dissipation layer 15 is provided between the intermediate layer 6 and the reflection layer 14. The heat dissipation layer 15 sufficiently dissipates heat which generates upon recording in the first information layer 10.

In order to achieve preferable recording and reproducing properties in the second information layer 20, the light transmittance of the first information layer 10 is required to be high. Therefore, in the optical recording medium of the present invention, the light transmission of the first information layer 10 is 40% or more, by adjusting the thickness of each of the layers in the first information layer 10. Specifically, it means to thin the recording layer 12. Since the material expressed by $Ga\alpha Sb\beta X\gamma$ is utilized, it is possible to attain a sufficient degree of modulation and crystallization speed, even with a thin recording layer 12. Accordingly, it is possible to attain good recording and reproducing, even with double layer-structure optical recording medium, and provides an optical recording medium having a large recording capacity.

As shown in the above, the recording layer of an optical recording medium according to the present invention comprises Ga and Sb. The recording layer may further comprise other element(s). The recording layer may comprise other element(s) than Ga and Sb in 10atom % or less of a total content of Ga and Sb.

A preferable composition ratio of the element(s) to be added into the recording layer is 10atm% or less.

Here, in $Ga\alpha Sb\beta X\gamma$, "X" expresses an element other than Ga and Sb and a mixture thereof. In addition, "$\alpha$," "$\beta$," and "$\gamma$" each satisfy the relations of, in atm%, "$5 \leq \alpha \leq 20$," "$80 \leq \beta \leq 95$," "$0 < \gamma \leq 10$" and "$\alpha + \beta + \gamma = 100$." If "$\alpha$" is smaller than 5, crystallization speed is lowered and thus a recording and reproducing at a high linear velocity becomes difficult. On the other hand, if "$\alpha$" is larger than 20, cycle of repetitive overwriting may become deteriorated. If "$\beta$" is smaller than 80, a degree of modulation becomes as small as, for example, less than 0.4, between a reflectance of a recording mark and that of unrecorded space part. If "$\beta$" is larger than 95, cycle of repetitive overwriting may become less frequent. Furthermore, if "$\gamma$" is larger than 10, a storage properties may deteriorate.

The recording layer 2 can be formed by various vapor growth methods, including, for example, vacuum deposition method, sputtering method, plasma-CVD method, photo-CVD method, ion plating method, electron beam vacuum deposition method and the like. In particular, the sputtering method is preferable for mass production and for quality of film (layer), or the like.

The inventors have further confirmed that, by adding those

The optical recording medium according to one aspect of the present invention comprises Bi and Rh as the elements other than Ga and Sb. The optical recording medium focuses on a high-speed crystallization ability of Ga and Sb, and the inventors of the present invention have decided to employ GaSb for the components of the recording layer in order to attain a high-speed crystallization. Bi is also employed so as to improve such properties of GaSb that the initial crystallization is slightly difficult because of a high crystallization temperature. Addition of Bi has enabled higher crystallization speed and a sufficient degree of modulation. By further adding Rh, the archival stability and overwriting properties are improved.

The reason why the recording layer comprising Ga and Sb enables a high-speed crystallization has not yet been clear. An assumption has been made on that it is because the most adjacent distance between the atoms of Ga and Sb is 2.65Å (0.265nm) in the case of amorphous phase, and is 2.64Å (0.264nm) in the case of crystalline phase, and that the phase transferring between the amorphous phase to the crystalline phase can be carried out easily, accordingly.

Furthermore, having weak covalent bond, Bi enables weakening covalent bond of Ga and Sb. The crystallization temperature is lowered and re-arrangement of atoms is more easily enabled. Thus, the crystallization speed can be accelerated. Moreover, by adding Bi, a structure between amorphous phase and crystalline phase becomes largely changed, compared with that of GaSb alone. This results in a significant change of optical constant between amorphous and crystalline phases along with the phase transferring. Accordingly, it is possible to obtain a sufficient degree of modulation.

Although it is still unknown how the addition of Rh influences the improvement of archival stability and overwriting properties, an assumption has been made on that a passive state is created by adding Rh, and oxidation may be prevented. Since having a high melting point, Rh prevents substance flow during overwriting, and improves the overwriting properties, as a result.

A content of Bi is preferably 1atom% to 5atom% in the recording layer, and a content of Rh is preferably 1atom% to 3atom% in the recording layer.

Containing 1atom% or more of Bi in the recording layer, crystallization temperature becomes lower, and a degree of modulation improves. If the content of Bi is more than 5atom%, archival stability deteriorates. Containing 1atom% or more of Rh in the recording layer, archival stability and overwriting properties improve. If the content of Rh is less than 3atom%, recording sensitivity deteriorates. In this aspect, the content of Sb is preferably 94atom% or less in the recording layer.

The recording layer which comprises Bi and Ri in addition to Ga and Sb, may further comprise at least one element selected from Cu, B, N, Ge, Fe, and Ir. The optical recording medium having the above recording layer may have a sufficient degree of modulation, with an equivalent capacity of that of DVD-ROM at a recording linear velocity of 3.0 m/s to 35 m/s. The optical recording medium also have good overwriting repetitive properties, and have better archival stability.

It is considered to be because in the case of B, N and Ge, those elements have strong covalent bonding property, and thus tend to be connected with an unconnected bond of host material (elements contained in the recording layer), which prevents oxidation. It is still not clear how Cu, Fe, and Ir improve the archival stability. An assumption has been made on that Cu, Fe, and Ir also tend to connect with unconnected bonds of the host material, which prevents oxidation.

A content of at least one element selected from Cu, B N, Ge, Fe, and Ir is preferably 1atom% to 3 atom% in the recording layer. If the content of the element is less than 1atom %, there is no effect derived from the addition, which is not preferable. If the content of the element is more than 3atom%, the crystallization speed become lowered, which is not preferable.

In the aspect of the present invention above, thicknesses of the first protective layer and the second protective layer is preferably 20nm to 300nm.

The first protective layer and the second protective layer are each preferably formed by sputtering method using ZnS and $SiO_2$.

The first protective layer and the second protective layer each play a role of protecting the optical recording medium from heat (a role of a heat resistant layer) at the same time as playing a role of a light interference layer.

If the thickness of the first protective layer is less than 200Å (20nm), the first protective layer does not work as the heat resistant layer that prevents damage to the substrate from heat. If the thickness of the first protective layer is more than 3000Å (300nm), the separation of interface between layers, is more likely to occur. The thickness of the first protective layer is therefore preferably 200Å (20nm) to 3000Å (300nm). In order to work as the light interfering layer, the thickness of the first protective layer more preferably satisfies a relation of:

$$0.070\lambda \le t_1 \le 0.16\lambda,$$

wherein "$t_1$" expresses the thickness of the first protective layer, and "$\lambda$" expresses the wavelength of the laser beam.

The second protective layer plays a role of effectively dissipating the heat absorbed in the recording layer toward the reflection layer, and a role of preventing a reaction between the recording layer and the reflection layer.

The thickness of the second protective layer is preferably 20Å (2nm) or more. The second protective layer is formed preferably as thin as possible. If the second protective layer is too thin, however, the beam power upon recording has to be large. When using a laser beam having wavelength of 630nm to 700 nm, as utilized in DVDs, the thickness of the second protective layer preferably satisfies a relation of:

$$0.011\lambda \le t_3 \le 0.040\lambda,$$

wherein "$t_3$" expresses the thickness of the second protective layer, and "$\lambda$" expresses the wavelength of the laser beam.

The recording layer of the aspect of the present invention above is formed ordinarily by sputtering method. A thickness of the recording layer of the aspect is preferably 10nm to 100nm, and more preferably 20nm to 35nm.

If the thickness of the recording layer is smaller than 10nm, light absorption properties deteriorate, and a function as a recording layer is lost. If the thickness of the recording layer is larger than 100nm, a less laser beam is transmitted, and an interference effect cannot be expected.

The reflection layer of the aspect comprises Ag alloy. The reflection layer can be formed by the sputtering method. The reflection layer works also as a heat dissipation layer. A preferable thickness of the reflection layer is 50nm to 200nm, and more preferably, 70nm to 150nm.

In an optical recording medium according to another aspect of the present invention, the recording layer comprises Zr and Mg, as the other elements than Ga and Sb. In the other words, the present invention focuses on high speed crystallization speed derived from Ga and Sb. This is why Ga and Sb are contained in the recording layer of the optical recording medium of the present invention. Mg is employed so as to improve such properties of GaSb that the initial crystallization is slightly difficult because of its high crystallization temperature.

Addition of Mg enables lowering the crystallization temperature of GaSb, higher speed crystallization and a sufficient degree of modulation. Addition of Zr to the GaSb further improves archival stability and overwriting properties of the recording layer.

The reason why the recording material which contains a combination of Ga and Sb, Zr, and Mg enables a high speed crystallization have not yet been clear. An assumption has been made on that it is because the most adjacent distance between the atoms of GaSb alloy is.2.65Å (0.265nm) in the case of amorphous phase, and is 2.64Å (0.264nm) in the case of crystalline phase, and that the phase transferring between the amorphous phase to the crystalline phase can be carried out with slight transferring of the atoms, accordingly.

Decrease in crystallization temperature because of addition of Mg is derived from weakening the bonding among Ga-Sb-Mg alloy, since Mg has weak covalent bonding. Re-arrangement of atoms is more easily enabled. Thus, the crystallization speed can be accelerated. Moreover, by adding Mg, a structure between amorphous phase and crystalline phase becomes largely changed, compared with that of GaSb alloy. This results in a significant change of optical constant between amorphous and crystalline phases along with the phase transferring. Accordingly, it is possible to improve the degree of modulation.

Although it is still not very clear how the addition of Zr influences the improvement of archival stability and overwriting properties, an assumption has been made on that a high melting point of Zr controls a substance flow, thereby the overwriting properties are improved. Furthermore, a passive state is easily created by adding Zr, which prevents oxidization, thereby improving the archival stability.

According to the above aspect of the present invention, by use of the phase change alloy of the above composition for the recording layer, it is possible to obtain a optical recording medium having a large recording capacity equivalent to that of DVD-ROM, and even at a wide range of recording linear velocity of 3.5 m/s to 35 m/s, including a high linear velocity of 25 m/s or more, and it still improves the degree of modulation, good in overwriting and its repeating property, and further a high archival stability.

In the aspect above, a content of Zr in the recording layer is preferably 0.5atom% to 5atom%, and a content of Mg in the recording layer is preferably 1atom % to 6atom%.

Containing 0.5atom% or more of Zr in the recording layer improves archival stability and overwriting properties. If the content of the Zr is more than 5atom%, crystallization speed and recording sensitivity deteriorate. Containing 1atom% or more of Mg in the recording layer lowers crystallization temperature, and enables easier initial crystallization, and further accelerates crystallization speed. Moreover, containing 1atom% of Mg enables faster crystallization speed, enables easier overwriting at a high linear velocity of 35m/s, and improves the degree of modulation.

If the content of Mg is more than 6atom%, archival stability deteriorates.

In the aspect above, a content of Ga is preferably 6atom% or more, from a viewpoint of crystallization speed. A content of Sb here is preferably 90atom% or less, from a viewpoint of improving the number of cycle of repetitive overwriting.

As a further preferable phase change alloy to be used for the recording layer, there is suggested a recording material in the recording layer comprising Ga, Sb, Zr, and Mg, together with one element selected from Al, C, N, Se, and Sn. When Al, C, N, and Se are added, the archival stability is further improved. When Al, and Sn are added, the crystallization speed is further improved and overwriting can be carried out at a linear velocity of, for example, 35m/s, on the other hand.

A content of the element selected from Al, C, N, Se, and Sn in the recording layer is preferably 1atom% to 3atom%. Containing 1atm% or more of the element in the recording layer enables exhibiting the above effects such as good archival stability, overwriting properties at the linear velocity of 35m/s, or the like.

Containing more than 3atom% of the element in the recording layer, recording sensitivity deteriorates in a case of Al, C, N, Se, and crystallization temperature decreases and hence archival stability deteriorates in a case of Sn.

The content of Ga, Sb, Zr, and Mg in the recording layer and the reason for the contents are the same as the previously given reasons for the case of Ga, Sb, Zr, and Mg.

The recording layer can be formed by various vapor growth methods, for example, sputtering method, as described in the above. In the aspect above, the thickness of the recording layer is 10nm to 100nm, and more preferably 20nm to 35nm.

If the recording layer is thinner than 10nm, light absorption ability deteriorates, and a function as a recording layer may be lost. If the recording layer is thicker than 100nm, less light is transmitted to the recording layer, and an interference effect may not be expected.

A material of substrate 7 is ordinarily, glass, ceramics or a resin. Of these, a resin is preferable from a viewpoint of capability of forming and cost. Specific examples of the resin include a polycarbonate resin, an acrylic resin, an epoxy resin, a polystyrene resin, an acrylonitrile-styrene copolymer resin, a polyethylene resin, a polypropylene resin, a silicone resin, a fluorine resin, an ABS resin, a urethane resin, and the like. Of these, a polycarbonate resin or an acrylic resin such as polymethyl methacrylate (PMMA) or the like is preferable from a viewpoint of capability of forming, optical properties, and cost. Concavoconvex patterns such as guide grooves are formed on the substrate 7, and the substrate 7 is formed by injecting molding or a photopolymer method. The formation or the shape of the substrate 7 can be any of disk, card, sheet or the like.

Materials of a reflection layer 4 can be metals such as Al, Au, Ag, Cu, Ta, and W, or an alloy thereof. Of these, Ag, Cu, Au is preferably used as the material when recording at a high linear velocity. Cr, Ti, Si, Pd, Ta, Cu, In, Mn, or the like, can be added to the reflection layer 4 either alone or in combination of two or more. The reflection layer 4 can be formed by various vapor growth methods, for example, vacuum deposition method, sputtering method, plasma-CVD method, photo-CVD method, ion plating method, electron beam vacuum deposition method or the like. Of these, the sputtering method is preferable for mass production, for quality of the layer, and the like.

The first protective layer 1 plays a role of protecting the recording layer 2 so that impurities such as moisture or the like from the substrate 7 is not to be included in a recording layer, of preventing thermal damage on the substrate 7, and of adjusting optical properties, and the like. Therefore, the first protective layer 1 preferably is unlikely to penetrate moisture, preferably has good heat resistance, a small absorptance (k) and refractive index (n).

Materials of the first protective layer 1 and the second protective layer 3 can be metal oxide such as SiO, $SiO_2$, ZnO, $SnO_2$, $Al_2O_3$, $TiO_2$ $In_2O_3$, MgO, $ZrO_2$, or the like; nitride such as $Si_3N_4$, AlN, TiN, ZrN, or the like; sulfide such as ZnS, $In_2S_3$, $TaS_4$, or the like; carbides such as SiC, TaC, $B_4C$, WC, TiC, ZrC, or the like; diamond like carbon, and the like. These materials can be used either alone or in a mixture of two or more in order to form each of the first and second protective layers. In addition, these materials may inevitably include impurities. It is necessary that a melting point of the first protective layer 1 and that of the second protective layer 3 are higher than that of the recording layer 2. The first protective layer 1 and the second protective layer 3 can be formed by various vapor growth methods, for example, vacuum deposition method, sputtering method, plasma-CVD method, photo-CVD method, ion plating method, electron beam vacuum deposition method or the like. Of these, the sputtering method is preferable for mass production, for quality of the layer, and the like. It is preferable to form the first protective layer 1 and the second protective layer 3 by sputtering method, using (ZnS) · ($SiO_2$).

Material of the light transmittance layer 5 is preferably resin, from a viewpoint of ability of forming and cost. Examples of the resin include a polycarbonate resin, an acrylic resin, an epoxy resin, a polystyrene resin, an acrylonitrile-styrene copolymer resin, a polyethylene resin, a polypropylene resin, a silicone resin, a fluorine resin, an ABS resin, a urethane resin and the like. Of these, a polycarbonate resin or an acrylic resin such as polymethyl methacrylate (PMMA), or the like, is preferable from viewpoints of ability of forming, optical properties, and cost. It is also preferable to use an ultraviolet setting resin.

The light transmittance layer 5 may have concavoconvex patterns such as guide grooves. The concavoconvex patterns are molded by injecting molding or a photopolymer method, as in the substrate 7.

Examples of the material for the intermediate layer include ITO formed of InO and SnO, and the like.

Examples of an overcoat layer, which will be mentioned in the followings, include an acrylic resin, and the like.

EXAMPLES

The present invention will be described in more detail with reference to the following EXAMPLES which are not intented to limit the invention.

The following EXAMPLEs D-1 to D-7 and COMPARATIVE EXAMPLES D-1 and D-4 indicate an aspect of the present invention, where the recording layer of an optical recording medium contains Ga, Sb,Bi and Rh. EXAMPLES D8-D10 arte not falling under the scope of the present invention.

(EXAMPLES D-1 to D-10, COMPARATIVE EXAMPLES D-1 to D-4)

In order to manufacture an optical recording medium having a composition as shown in TABLE 1, on a 0.6mm thick polycarbonate substrate having track pitch of $0.7\mu m$, groove depth of 400Å (40nm), and a diameter of 120mm, a first protective layer (thickness: 700Å (70nm)), a recording layer (thickness: 150Å (15nm)), an second protective layer (thickness: 250Å (25nm)), and a reflection layer (thickness: 1000Å (100nm)) were sequentially formed by a sputtering method, and further on the reflection layer, an surrounding protective layer was provided by spin coating method. Subsequently, after having thus obtained optical recording medium subjected to initial crystallization, signal property of the optical recording medium was evaluated. In order to evaluate a response against higher linear velocity, evaluation items were determined as follows: recording linear velocity and recording power were 3.5m/s (10mW), 15m/s (16mW), 25m/s (26mW), and 35m/s (36mW), respectively. Wavelength of recording laser beam was 650nm, overwriting was repeated in EFM (Eight to Fourteen Modulation) random pattern. Evaluation of reproduced signal property was conducted as to a jitter value of 3T signal and a degree of modulation of 14T signal. A archival stability was evaluated by 3T. signal jitter value and 14T signal degree of modulation at the 1000 times of overwriting, as to the optical recording medium, which had been overwritten for 1000 times and maintained for 300 hours under the temperature of 80°C and humidity of 85RH%. The result is shown in the following TABLE 2 Table 3 and Table 4.

[TABLE 1]

|  | First protective layer | Recording layer | Second protective layer | Reflection layer |
|---|---|---|---|---|
| Ex. D-1 | $(ZnS)_{80}(SiO_2)_{20}$ (mol%) | Ga10Sb85Bi3Rh2 (atm%) | $(znS)_{80}(SiO_2)_{20}$(mol%) | Ag96Cu2Ni2 |
| Ex. D- 2 | $(ZnS)_{80}(SiO_2)_{20}$ | Ga9Sb85Bi3Rh2Cu1 | $(ZnS)_{80}(SiO_2)_{20}$ | Ag96Cu2Ni2 |
| Ex. D- 3 | $(ZnS)_{80}(SiO_2)_{20}$ | Ga9Sb85Bi3Rh2B1 | $(ZnS)_{80}(SiO_2)_{20}$ | $Ag_{96}Cu2Ni_2$ |
| Ex. D- 4 | $(ZnS)_{80}(SiO_2)_{20}$ | Ga9Sb85Bi3Rh2N1 | $(ZnS)_{80}(SiO_2)_{20}$ | Ag96Cu2Ni2 |
| Ex. D- 5 | $(ZnS)_{80}(SiO_2)_{20}$ | Ga9Sb85Bi3Rh2Ge1 | $(ZnS)_{80}(SiO2)_{20}$ | Ag96Cu2Ni2 |
| Ex. D- 6 | $(ZnS)_{80}(SiO_2)_{20}$ | Ga9Sb85Bi3Rh2Fe1 | $(ZnS)_{80}(SiO_2)_{20}$ | Ag96Cu2Ni2 |
| Ex. D-7 | $(ZnS)_{80}(SiO_2)_{20}$ | Ga9Sb85Bi3Rh2Ir1 | $(ZnS)_{80}(SiO_2)_{20}$ | Ag96Cu2Ni2 |
| Ex. D-8 | $(ZnS)_{80}(SiO_2)_{20}$ | Ga12Sb88 | $(ZnS)_{80}(SiO_2)_{20}$ | Ag96Cu2Ni2 |
| Ex. D-9 | $(ZnS)_{80}(SiO_2)_{20}$ | Ga10Sb88Bi2 | $(ZnS)_{80}(SiO_2)_{20}$ | Ag96Cu2Ni2 |
| Ex. D-10 | $(ZnS)_{80}(SiO_2)_{20}$ | Ga10Sb88Ge2 | $(ZnS)_{80}(SiO_2)_{20}$ | Ag96Cu2Ni2 |
| Comp. Ex. D-1 | $(ZnS)_{80}(SiO_2)_{20}$ | Ga50Sb50 | $(ZnS)_{80}(SiO_2)_{20}$ | Ag96Cu2Ni2 |
| Comp.Ex. D-2 | $(ZnS)_{80}(SiO_2)_{20}$ | Ga4Sb96 | $(ZnS)_{80}(SiO_2)_{20}$ | Ag96Cu2Ni2 |
| Comp.Ex. D-3 | $(ZnS)_{80}(SiO_2)_{20}$ | Ga2Sb96Bi1Rh1 | $(ZnS)_{80}(SiO_2)_{20}$ | Ag96Cu2Ni2 |
| Comp.Ex. D-4 | $(ZnS)_{80}(SiO_2)_{20}$ | AgIIn3Sb80Te16 | $(ZnS)_{80}(SiO_2)_{20}$ | Ag96Cu2Ni2 |

As for initial crystallization, in EXAMPLES D-1 to D-10, and in COMPARATIVE EXAMPLE D-4, a semiconductor laser with 700 mW output was used. In COMPARATIVE EXAMPLE D-1, a semiconductor laser with 1000 mW output was used.

[TABLE 2]

| | Recording Linear Velocity (m/s) | Recording Power (mW) | Jitter Value after Overwriting | | Degree of Modulation (M) after Overwriting | | Reflectance, Rg(%) after Overwriting | | Archival Stability | | Reflectance, Rb(%) after Overwriting | |
|---|---|---|---|---|---|---|---|---|---|---|---|---|
| | | | 1time | 1000 times | 1time | 1000 times | 1 time | 1000 times | Jitter Value (%) | Degree of Modulation (M) after Overwriting | 1time | 1000 times |
| EX. D-1 | 3.5 | 10 | 7.2 | 7.3 | 65 | 67 | 19.8 | 19.6 | 7.5 | 0.65 (65%) | 6.9 | 6.5 |
| | 15 | 16 | 7.2 | 7.3 | 65 | 67 | 19.7 | 19.4 | 7.5 | 0.65 (65%) | 6.9 | 6.4 |
| | 25 | 26 | 7.3 | 7.5 | 63 | 65 | 19.5 | 19.2 | 7.7 | 0.63 (63%) | 7.2 | 6.7 |
| | 35 | 36 | 7.6 | 7.8 | 62 | 64 | 19.3 | 18.9 | 8.0 | 0.62 (62%) | 7.3 | 6.8 |
| EX. D-2 | 3.5 | 10 | 7.1 | 7.4 | 66 | 68 | 20.4 | 20.2 | 7.6 | 0.66 (66%) | 6.9 | 6.5 |
| | 15 | 16 | 7.2 | 7.5 | 65 | 68 | 20.3 | 20.0 | 7.7 | 0.65 (65%) | 7.1 | 6.4 |
| | 25 | 26 | 7.3 | 7.6 | 64 | 66 | 20.0 | 19.7 | 7.8 | 0.64 (64%) | 7.2 | 6.7 |
| | 35 | 36 | 7.6 | 7.9 | 63 | 65 | 19.8 | 19.5 | 8.1 | 0.63 (63%) | 7.3 | 6.8 |
| EX. D-3 | 3.5 | 10 | 7.2 | 7.3 | 68 | 70 | 20.0 | 19.7 | 7.4 | 0.68 (68%) | 6.4 | 5.9 |
| | 15 | 16 | 7.3 | 7.5 | 67 | 69 | 20.1 | 19.7 | 7.6 | 0.67 (67%) | 6.6 | 6.1 |
| | 25 | 26 | 7.4 | 7.6 | 66 | 68 | 19.9 | 19.5 | 7.7 | 0.66 (66%) | 6.8 | 6.2 |
| | 35 | 36 | 7.7 | 7.9 | 65 | 68 | 19.7 | 19.4 | 8.0 | 0.66 (66%) | 6.9 | 6.2 |
| EX. D-4 | 3.5 | 10 | 7.0 | 7.2 | 66 | 68 | 20.2 | 20.0 | 7.3 | 0.66 (66%) | 6.9 | 6.4 |
| | 15 | 16 | 7.2 | 7.4 | 66 | 68 | 20.0 | 19.8 | 7.5 | 0.66 (66%) | 6.8 | 6.3 |
| | 25 | 26 | 7.4 | 7.5 | 65 | 67 | 19.7 | 19.4 | 7.6 | 0.65 (65%) | 6.9 | 6.4 |
| | 35 | 36 | 7.7 | 7.8 | 63 | 66 | 19.7 | 19.3 | 8.0 | 0.64 (64%) | 7.3 | 6.6 |
| EX. D-5 | 3.5 | 10 | 7.1 | 7.1 | 67 | 69 | 20.2 | 19.9 | 7.2 | 0.67 (67%) | 6.7 | 6.2 |
| | 15 | 16 | 7.2 | 7.3 | 67 | 69 | 20.0 | 19.8 | 7.4 | 0.67 (67%) | 6.6 | 6.1 |
| | 25 | 26 | 7.3 | 7.4 | 66 | 68 | 19.8 | 19.5 | 7.5 | 0.66 (66%) | 6.7 | 6.2 |
| | 35 | 36 | 7.7 | 7.9 | 65 | 67 | 19.6 | 19.2 | 7.9 | 0.65 (65%) | 6.9 | 6.3 |

[TABLE 3]

| | Recording Linear Velocity | Recording Power | Jitter Value after Overwriting | | Degree of Modulation (M) after Overwriting | | Reflectance, Rg(%) after Overwriting | | Archival Stability | | Reflectance, Rb(%) after Overwriting | |
|---|---|---|---|---|---|---|---|---|---|---|---|---|
| | (m/s) | (mW) | 1time | 1000 times | 1time | 1000 times | 1time | 1000 times | Jitter Value (%) | Degree of Modulcation (M) after Overwriting | 1 time | 1000 times |
| EX. D-6 | 3.5 | 10 | 7.2 | 7.4 | 67 | 69 | 20.2 | 19.9 | 7.5 | 0.67 (67%) | 6.7 | 6.2 |
| | 15 | 16 | 7.5 | 7.6 | 67 | 69 | 20.0 | 19.8 | 7.7 | 0.67 (67%) | 6.6 | 6.1 |
| | 25 | 26 | 7.7 | 7.8 | 67 | 68 | 19.8 | 19.6 | 7.9 | 0.66 (66%) | 6.5 | 6.3 |
| | 35 | 36 | 7.8 | 7.9 | 66 | 68 | 19.5 | 19.3 | 8.0 | 0.66 (66%) | 6.6 | 6.2 |
| EX. D-7 | 3.5 | 10 | 7.0 | 7.2 | 66 | 68 | 20.4 | 20.0 | 7.3 | 0.66 (66%) | 6.9 | 6.4 |
| | 15 | 16 | 7.2 | 7.4 | 65 | 67 | 20.2 | 19.9 | 7.5 | 0.65 (65%) | 7.1 | 6.6 |
| | 25 | 26 | 7.4 | 7.6 | 64 | 66 | 20.0 | 19.8 | 7.7 | 0.64 (64%) | 7.2 | 6.7 |
| | 35 | 36 | 7.7 | 7.9 | 63 | 65 | 19.8 | 19.5 | 7.9 | 0.63 (63%) | 7.3 | 6.8 |
| EX. D-8 | 3.5 | 10 | 9.0 | 9.2 | 55 | 57 | 20.2 | 19.9 | 9.3 | 0.56 (56%) | 9.1 | 8.6 |
| | 15 | 16 | 8.7 | 9.0 | 63 | 64 | 20.0 | 19.8 | 9.1 | 0.62 (62%) | 7.4 | 7.1 |
| | 25 | 26 | 8.8 | 9.1 | 62 | 63 | 20.1 | 19.7 | 9.4 | 0.60(60%) | 7.6 | 7.3 |
| | 35 | 36 | 8.9 | 9.5 | 58 | 54 | 19.7 | 19.5 | 10.0 | 0.57 (57%) | 8.3 | 9.0 |
| EX. D-9 | 3.5 | 10 | 7.2 | 7.9 | 66 | 68 | 19.8 | 19.6 | 10.8 | 0.67 (67%) | 6.7 | 6.3 |
| | 15 | 16 | 7.3 | 8.1 | 65 | 67 | 19.7 | 19.6 | 11.0 | 0.66 (66%) | 6.9 | 6.5 |
| | 25 | 26 | 7.4 | 8.3 | 64 | 66 | 19.7 | 19.4 | 11.3 | 0.65 (65%) | 7.1 | 6.6 |
| | 35 | 36 | 7.7 | 8.8 | 63 | 65 | 19.6 | 19.3 | 11.8 | 0.64 (64%) | 7.3 | 6.8 |

[TABLE 4]

| | Recording Linear Velocity | Recording Power | Jitter Value after Overwriting | | Degree of Modulation (M) after Overwriting | | Reflectance, Rg(%) after Overwriting | | Archival Stability | | Reflectance, Rb(%) after Overwriting | |
|---|---|---|---|---|---|---|---|---|---|---|---|---|
| | (m/s) | (mW) | 1time | 1000 times | 1time | 1000 times | 1 time | 1000 times | Jitter Value (%) | Degree of Modulation (M) after Overwriting | 1 time | 1000 times |
| EX. D-10 | 3.5 | 10 | 9.0 | 9.5 | 54 | 56 | 19.5 | 19.2 | 9.7 | 0.56 (56%) | 9.0 | 8.4 |
| | 15 | 16 | 9.4 | 9.9 | 53 | 55 | 19.5 | 19.1 | 10.1 | 0.55 (55%) | 9.2 | 8.6 |
| | 25 | 26 | 9.9 | 10.5 | 52 | 54 | 19.3 | 19.1 | 10.7 | 0.54 (54%) | 9.3 | 8.8 |
| | 35 | 36 | 10.7 | 11.3 | 51 | 53 | 19.2 | 18.9 | 11.5 | 0.53 (53%) | 9.4 | 8.9 |
| COMP. EX. D-1 | 3.5 | 10 | 10.3 | 9.9 | 51 | 56 | 18.0 | 18.0 | 13.1 | 0.56 (56%) | 8.8 | 7.9 |
| | 15 | 16 | 10.7 | 10.5 | 50 | 56 | 17.9 | 17.5 | 14.1 | 0.55 (55%) | 9.0 | 7.7 |
| | 25 | 26 | 10.8 | 11.7 | 50 | 55 | 17.2 | 17.3 | 14.8 | 0.54 (54%) | 8.6 | 7.8 |
| | 35 | 36 | - | - | 45 | 48 | 17.0 | 16.9 | - | 0.42 (42%) | 9.4 | 8.8 |
| COMP. EX. D-2 | 3.5 | 10 | - | - | 42 | 43 | 25.0 | 24.6 | - | 0.40 (40%) | 14.5 | 14.0 |
| | 15 | 16 | 11.5 | 14.0 | 43 | 43 | 24.8 | 24.5 | 11.8 | 0.40 (40%) | 14.1 | 14.0 |
| | 25 | 26 | 11.0 | 12.0 | 45 | 46 | 24.3 | 24.0 | 10.3 | 0.42 (42%) | 13.4 | 13.0 |
| | 35 | 36 | - | - | 43 | 42 | 24.2 | 23.8 | - | 0.40 (40%) | 13.8 | 13.8 |
| COMP. EX. D-3 | 3.5 | 10 | - | - | 54 | 50 | 25.5 | 25.2 | - | 0.48 (48%) | 11.7 | 12.6 |
| | 15 | 16 | 12.0 | 12.5 | 56 | 54 | 25.4 | 25.0 | 13.5 | 0.52 (52%) | 11.2 | 11.5 |
| | 25 | 26 | 11.9 | 12.3 | 57 | 56 | 25.3 | 25.0 | 13.0 | 0.53 (53%) | 10.9 | 11.0 |
| | 35 | 36 | 12.3 | 12.6 | 52 | 50 | 25.0 | 24.6 | 13.8 | 0.47 (47%) | 12.0 | 12.3 |
| COMP. EX. D-4 | 3.5 | 10 | 7.1 | 7.3 | 65 | 68 | 19.5 | 19.2 | 7.5 | 0.65 (65%) | 6.8 | 6.1 |
| | 15 | 16 | 9.3 | 9.5 | 64 | 68 | 19.3 | 19.1 | 9.8 | 0.63 (63%) | 6.9 | 6.1 |
| | 25 | 26 | Unable to Overwrite | | | | | | | | | |
| | 35 | 36 | | | | | | | | | | |

As apparently shown in TABLE 2, TABLE 9, and TABLE 4, it was found out that the optical recording medium of the present invention enables overwriting even within a wide range of linear velocity of 3.5m/s,15 m/s (16 mW), 25m/s (26 mW), and 35m/s (36 MW), and in particular, at the linear velocity over 25m/s, which was considered to be difficult for overwriting in the related art. In addition, jitter value and degree of modulation of reproduced signal were excellent, archival stability and a repetition property in overwriting were also excellent. On the contrary, as for the optical recording medium of COMPARATIVE EXAMPLE D-1 using eutectic compositions one of Ga50Sb50, overwriting at a high linear velocity could be carried out, but had a poor jitter value, a poor degree of modulation, archival stability and repetition property in overwriting, and also initial crystallization was not easily carried out, comparing to the EXAMPLES. In addition, as for the material of Ag-In-Sb-Te in COMPARATIVE EXAMPLE D-2, overwriting at linear velocity of 25m/s and 35m/s could not be carried out.

According to an aspect of the present invention where the recording layer comprises Ga, Sb, Bi, and Rh, it is possible to provide an optical recording medium having a capacity equivalent to that of DVD-ROM, having a sufficient degree of modulation even at a wide range of recording linear velocity of 3.0 m/s to 35 m/s, excellent in repetition property in overwriting and superior in archival stability. Therefore, the present invention largely contributes to progress in a filed of optical recording.

The following EXAMPLES E-1 to E-6, and COMPARATIVE EXAMPLES E-1 and E-2 indicate an aspect of the present invention where the recording layer comprised Ga, Sb, Zr, and Mg.

(EXAMPLE E-1)

As shown in FIG. 2, on a 0.6mm thick polycarbonate substrate having track pitch of 0.7$\mu$m, groove depth of 400Å (40nm), diameter of 120mm, a first protective layer 2(thickness: 750Å (75nm)) comprising $(ZnS)_{80}(SiO_2)_{20}$ (mol%), a recording layer (thickness :150Å (15nm)) comprising Ga10Sb88Zr1Mg1, a second protective layer 4 (thickness: 300Å (30nm)) comprising $(ZnS)_{80}(SiO_2)_{20}$ (mol%) and a reflection layer 5(thickness: 950Å (95nm)) comprising Ag alloy, were sequentially disposed by a sputtering method. On the reflection layer 5, an surrounding protective layer 6(thickness: around 5 nm) comprising an acrylic resin was formed by a spin coating method, whereby a optical recording medium for evaluation having a layer structure as shown in FIG. 2 was manufactured.

TABLE 5 shows composition ratio of the material and thickness of each of the layers.

(EXAMPLES E-2 to E-6)

A optical recording medium for evaluation for use in the EXAMPLES E-2 to E-6 was manufactured in the same manner as in EXAMPLE E-1, except that Ga10Sb88Zr1Mg1, used as material for the recording layer, was replaced by the following materials:

· Ga9Sb88ZrlMglAll (EXAMPLE E-2)
· Ga9Sb87Zr1Mg1Sn2 (EXAMPLE E-3)
· Ga10Sb87Zr1Mg1Se1 (EXAMPLE E-4)
· Ga9Sb87Zr1Mg2N1. (EXAMPLE E-5)
· Ga10Sb87Zr1Mg1C1 (EXAMPLE E-6)

TABLE 5 shows, in summary, composition ratio of the material and thickness of each of the layers in EXAMPLES E-2 to E-6.

[TABLE 5]

| | First protective layer | | Recording layer | | Second protective layer | | Reflection layer | |
|---|---|---|---|---|---|---|---|---|
| | Material composition (mol %) | Thickness (Å)/(nm) | Material composition (atm%) | Thickness (Å)/(nm) | Material composition (mol %) | Thickness (Å)/(nm) | Material | Thickness (Å) /(nm) |
| Ex. E-1 | $(ZnS)_{80}(SiO_2)_{20}$ | 750/75 | Ga10Sb88Zr1Mg1 | 150/15 | $(ZnS)_{80}(SiO_2)_{20}$ | 300/30 | Ag alloy | 950/95 |
| Ex. E-2 | $(ZnS)_{80}(SiO_2)_{20}$ | 750/75 | Ga9Sb88Zr1Mg1Al1 | 150/15 | $(ZnS)_{80}(SiO_2)_{20}$ | 300/30 | Ag alloy | 950/95 |
| Ex. E-3 | $(ZnS)_{80}(SiO_2)_{20}$ | 750/75 | Ga9Sb87Zr1Mg1Sn2 | 150/15 | $(ZnS)_{80}(SiO_2)_{20}$ | 300/30 | Ag alloy | 950/95 |
| Ex. E-4 | $(ZnS)_{80}(SiO_2)_{20}$ | 750/75 | Ga10Sb87Zr1Mg1Se1 | 150/15 | $(ZnS)_{80}(SiO_2)_{20}$ | 300/30 | Ag alloy | 950/95 |
| Ex. E-5 | $(ZnS)_{80}(SiO_2)_{20}$ | 750/75 | Ga9Sb87Zr1Mg2N1 | 150/15 | $(ZnS)_{80}(SiO_2)_{20}$ | 300/30 | Ag alloy | 950/95 |
| Ex. E-6 | $(ZnS)_{80}(SiO_2)_{20}$ | 750/75 | Ga10Sb87Zr1Mg1C1 | 150/15 | $(Zn_2)_{80}(SiO_2)_{20}$ | 300/30 | Ag alloy | 950/95 |

(COMPARATIVE EXAMPLES E-1 and E-2)

An optical recording media for evaluation for use in the COMPARATIVE EXAMPLES E-1 and E-2 were manufactured in the same manner as described in EXAMPLE E-1, except that the composition ratio of the material in the recording layer and thicknesses were changed as shown in TABLE 6. It should be noted that as shown in TABLE 6, the thicknesses of the recording layer, the second protective layer and reflection layer vary among the COMPARATIVE EXAMPLES.

[TABLE 6]

| Comparative examples | First protective layer | | Recording layer | | Second protective layer | | Reflection layer | |
|---|---|---|---|---|---|---|---|---|
| | Material composition (mol %) | Thickness (Å)/(nm) | Material composition (atm%) | Thickness (Å) /(nm) | Material composition (mol %) | Thickness (Å) /(nm) | Material | Thickness (Å) /(nm) |
| Comp. Ex. E-1 | $(ZnS)_{80}(SiO_2)_{20}$ | 750/75 | Ga50Sb50 | 160/16 | $(ZnS)_{80}(SiO_2)_{20}$ | 200/20 | Ag alloy | 9000/900 |
| Comp. Ex. E-2 | $(ZnS)_{80}(SiO_2)_{20}$ | 750/75 | Ag1In3Sb80Te16 | 160/26 | $(ZnS)_{80}(SiO_2)_{20}$ | 200/20 | Ag alloy | 1000/100 |

The recording layer of the optical recording media manufactured in the EXAMPLES E-1 to E-6 and COMPARATIVE EXAMPLES E-1 and E-2 was amorphous, and for evaluation, the optical recording media was subjected to initial crystallization (initialization) and rendered in unrecorded state. Here, in the EXAMPLES E-1 to E-6 and COMPARATIVE EXAMPLEs E-1 and E-3, high output semiconductor laser was used, and initialization was carried out at 700mW output. However, as to the COMPARATIVE EXAMPLE E-1, initialization failed with the 700mW output laser, and thus it was carried out at the condition of 1100 mW output.

After initialization, a reproduced signal property and storage property of each evaluation-purpose optical recording medium (recording medium) were evaluated.

The evaluation was carried out by setting the recording linear velocity and recording power (in parenthesis), 3.5m/s (10mW), 15m/s (16mW), 25m/s (26mW), and 35m/s (36mW), respectively. Wavelength of a recording laser beam was 650nm, overwriting was repeated in EFM (Eight to Fourteen Modulation, 8-14 modulation) random pattern. Evaluation of reproduced signal property was conducted with a jitter value of 3T signal and a degree of modulation of 14T signal. A storage property was evaluated by 3T signal jitter value and 14T signal degree of modulation at the 1000th time of overwriting, as to the optical recording medium, which had been overwritten for 1000 times and maintained for 300 hours at the temperature of 80°C and humidity of 85% .

The results of evaluation of the EXAMPLES E-1 to E-6 and COMPARATIVE EXAMPLES E-1 and E-2 are shown in the following TABLE 7 and TABLE 8.

[TABLE 7]

| | Recording linear velocity, (m/s) | Recording power (mW) | Jitter value (%) after overwriting | | Degree of modulation (%) after overwriting | | Archival stability | |
|---|---|---|---|---|---|---|---|---|
| | | | 1time | 1,000times | 1time | 1,000times | Jitter value (%) | Degree of modulation (%) |
| Ex. E-1 | 3.5 | 10 | 7.3 | 7.5 | 66 | 68 | 7.6 | 66 |
| | 15 | 16 | 7.3 | 7.5 | 65 | 68 | 7.6 | 65 |
| | 25 | 26 | 7.5 | 7.7 | 65 | 67 | 7.8 | 64 |
| | 35 | 36 | 7.8 | 8.0 | 63 | 65 | 8.1 | 63 |
| Ex. E-2 | 3.5 | 10 | 7.3 | 7.4 | 66 | 68 | 7.5 | 66 |
| | 15 | 16 | 7.3 | 7.5 | 66 | 68 | 7.5 | 66 |
| | 25 | 26 | 7.5 | 7.7 | 65 | 67 | 7.7 | 65 |
| | 35 | 36 | 7.8 | 8.0 | 64 | 66 | 8.0 | 64 |
| Ex. E-3 | 3.5 | 10 | 7.2 | 7.4 | 67 | 69 | 7.6 | 66 |
| | 15 | 16 | 7.2 | 7.4 | 67 | 69 | 7.6 | 66 |
| | 25 | 26 | 7.3 | 7.5 | 67 | 69 | 7.6 | 66 |
| | 35 | 36 | 7.5 | 7.7 | 66 | 68 | 7.9 | 65 |
| Ex. E-4 | 3.5 | 10 | 7.4 | 7.5 | 64 | .66 | 7.6 | 64 |
| | 15 | 16 | 7.4 | 7.5 | 64 | 66 | 7.6 | 64 |
| | 25 | 26 | 7.5 | 7.6 | 64 | 66 | 7.7 | 64 |
| | 35 | 36 | 7.7 | 7.8 | 63 | 65 | 7.9 | 63 |
| Ex. E-5 | 3.5 | 10 | 7.5 | 7.5 | 62 | 64 | 7.6 | 62 |
| | 15 | 16 | 7.5 | 7.6 | 62 | 64 | 7.7 | 62 |
| | 25 | 26 | 7.6 | 7.7 | 62 | 64 | 7.8 | 62 |
| | 35 | 36 | 7.7 | 7.8 | 61 | 63 | 7.9 | 61 |

[TABLE 8]

| | Recording linear velocity (m/s) | Recording power (mW) | Jitter value (%) after overwriting | | Degree of modulation (%) after overwriting | | Archival stability | |
|---|---|---|---|---|---|---|---|---|
| | | | 1 time | 1,000 times | 1 time | 1,000 times | Jitter value (%) | Degree of modulation (%) |
| Ex.E-6 | 3.5 | 10 | 7.5 | 7.6 | 65 | 66 | 7.7 | 65 |
| | 15 | 16 | 7.5 | 7.6 | 65 | 66 | 7.7 | 65 |
| | 25 | 26 | 7.7 | 7.8 | 64 | 65 | 7.9 | 64 |
| | 35 | 36 | 7.8 | 7.9 | 63 | 64 | 8.0 | 63 |
| Comp. Ex. E-1 | 3.5 | 10 | 9.1 | 9.7 | 52 | 57 | 12.9 | 54 |
| | 15 | 16 | 9.7 | 10.5 | 51 | 55 | 13.8 | 53 |
| | 25 | 26 | 10.8 | 11.6 | 49 | 54 | 14.6 | 52 |
| | 35 | 36 | 11.9 | 12.9 | 48 | 53 | 15.6 | 51 |
| Comp. Ex. E-2 | 3.5 | 10 | 7.1 | 7.3 | 65 | 68 | 7.5 | 65 |
| | 15 | 16 | 9.2 | 9.4 | 64 | 68 | 9.7 | 63 |
| | 25 | 26 | * | * | * | * | * | * |
| | 35 | 36 | * | * | * | * | * | * |
| Here, "* " expresses "unable to overwriting." | | | | | | | | |

Obviously from TABLE 7 and TABLE 8, it was found out that the optical recording medium that uses recording materials comprising phase change alloy of the above aspect of the present invention, overwriting can be carried out even within a wide range of linear velocity of 3.5m/s to 35m/s, and in particular, at the high linear velocity at 25m/s or more, which was considered to be difficult for overwriting in the related art. In addition, jitter value and degree of modulation of reproduced signal are excellent, and the optical recording medium had excellent archival stability and a repetition property in overwriting.

On the contrary, as for the optical recording medium in the COMPARATIVE EXAMPLEs E-1 and E-2, using as a recording material, alloy having composition ratio of Ga50Sb50, or alloy having eutectic composition ratio of Ga12Sb88, overwriting at a high linear velocity can be carried out, but has a poor jitter value, a poor degree of modulation, a poor archival stability and a poor repetition property in overwriting.

Further, Ag-In-Sb-Te alloy in the COMPARATIVE EXAMPLE E-2, overwriting at linear velocity of 25m/s and 35m/ s could not be carried out.

According to another aspect of the present invention where the recording layer comprises Ga, Sb, Zr, and Mg, the present invention can provide a optical recording medium having a large capacity equivalent to that of DVD-ROM, even at a wide range of recording linear velocity from 3.5 m/ s to 35 m/ s, including 25 m/ s or more, having a sufficient degree of modulation, excellence in repetition property in overwriting and in archival stability.

According to the above aspect of the present invention, when the recording layer further comprises at least one element selected from Al, C, N, Se, and Sn, the present invention can provide an optical recording medium having a further enhanced archival stability or high-speed crystallization.

According to an aspect of the present invention where the optical recording medium further comprises a surrounding protective layer, the present invention can provide a optical recording medium in which, at high speed recording linear velocity, large capacity, a sufficient degree of modulation, maintenance of repetition property in overwriting, and maintenance of archival stability can be attained.

**Claims**

1. An optical recording medium comprising:

   a substrate (7); and
   a recording layer (2) disposed on the substrate, recording and erasing being carried out by a reversible phase change between an amorphous phase and a crystalline phase in the recording layer,

wherein the recording layer contains Ga and Sb, the content of Sb being 80 atom% to 95 atom% relative to the total content of Ga and Sb in the recording layer, and
wherein the recording layer further contains either Bi and Rh or Zr and Mg as additional elements.

2. An optical recording medium according to Claim 1, wherein the recording layer containing Ga, Sb, Bi and Rh further contains one element selected from Cu, B, N, Ge, Fe and Ir.

3. An optical recording medium according to Claim 1, wherein the recording layer containing Ga, Sb, Zr and Mg further contains one element selected from Al, C, N, Se and Sn.

4. An optical recording medium according to any one of Claims 1 to 3, wherein the total content of Ga and Sb is 90 atom% or more in the recording layer.

5. An optical recording medium according to Claim 4, wherein the total content of Ga and Sb in the recording layer is 95 atom% or more.

6. An optical recording medium according to any one of Claims 1 to 5, wherein the content of Sb is 85 atom% to 95 atom% relative to the total content of Ga and Sb in the recording layer.

7. An optical recording medium according to any one of Claims 2 to 6, wherein the optical recording medium includes:

the substrate (7);
a first protective layer (1);
the recording layer (2);
a second protective layer (3); and
a reflection layer (4),

wherein the first protective layer, the recording layer, the second protective layer, and the reflection layer are disposed on the substrate in this order, and a thickness of the reflection layer satisfies a relation of: $0.10\lambda$ or more, when the "$\lambda$" expresses the wavelength of the laser beam used for recording or erasing.

8. An optical recording medium according to any one of Claims 2 to 7, wherein the laser beam used for recording or erasing has the wavelength of 630 nm to 700 nm.

9. An optical recording medium according to Claim 8, wherein the optical recording medium includes:

the substrate (7);
a first protective layer (1);
the recording layer (2);
a second protective layer (3); and
a reflection layer (4)

wherein the first protective layer, the recording layer, the second protective layer, and the reflection layer are disposed on the substrate in this order, and each of a thickness of the first protective layer, a thickness of the recording layer, a thickness of the second protective layer, and a thickness of the reflection layer satisfies the following relations, when "$\lambda$" expresses the wavelength of the laser beam used for recording or erasing;

$$0.070\lambda \leq t_1 \leq 0.16\lambda$$

$$0.015\lambda \leq t_2 \leq 0.032\lambda$$

$$0.011\lambda \leq t_3 \leq 0.040\lambda$$

$$0.10\lambda \le t_4 ;$$

wherein "$t_1$" expresses the thickness of the first protective layer, "$t_2$" expresses the thickness of the recording layer, "$t_3$" expresses the thickness of the second protective layer, and "$t_4$" expresses the thickness of the reflection layer.

10. An optical recording medium according to one of Claims 8 and 9, wherein the thickness of the recording layer is 5 nm to 25 nm.

11. An optical recording medium according to Claim 10, wherein the thickness of the recording layer is 8 nm to 20 nm.

12. An optical recording medium according to any one of Claims 2 to 7, wherein the laser beam used for recording or erasing has wavelength of 350 nm to 450 nm.

13. An optical recording medium according to Claim 12, wherein the optical recording medium includes:

the substrate (7);
a first protective layer (1);
the recording layer (2);
a second protective layer (3); and
a reflection layer (4);

wherein the first protective layer, the recording layer, the second protective layer, and the reflection layer are disposed on the substrate in this order, and each of a thickness of the first protective layer, a thickness of the recording layer, a thickness of the second protective layer, and a thickness of the reflection layer satisfies the following relations, when "$\lambda$" expresses the wavelength of the laser beam used for recording or erasing;

$$0.070\lambda \le t_1 \le 0.5\lambda$$

$$0.015\lambda \le t_2 \le 0.05\lambda$$

$$0.011\lambda \le t_3 \le 0.055\lambda$$

$$0.10\lambda \le t_4 ;$$

wherein "$t_1$" expresses the thickness of the first protective layer, "$t_2$" expresses the thickness of the recording layer, "$t_3$" expresses the thickness of the second protective layer, and "$t_4$" expresses the thickness of the reflection layer.

14. An optical recording medium according to Claim 12, wherein the optical recording medium includes:

the substrate (7);
a reflection layer (4);
a second protective layer (3);
the recording layer (2);
a first protective layer (1); and
a light transmittance layer (5),

wherein the reflection layer, the second protective layer, the recording layer, the first protective layer, and the light transmittance layer are disposed on the substrate in this order, and each of a thickness of the reflection layer, a thickness of the second protective layer, a thickness of the recording layer, and a thickness of the first protective layer, and a thickness of the light transmittance layer satisfies the following relations, when "λ" expresses the wavelength of the laser beam used for recording or erasing;

$$0.10\lambda \ \le \ t_4 \ \le \ 0.75\lambda$$

$$0.011\lambda \ \le \ t_3 \ \le \ 0.055\lambda$$

$$0.015\lambda \ \le \ t_2 \ \le \ 0.05\lambda$$

$$0.070\lambda \ \le \ t_1 \ \le \ 0.5\lambda$$

$$0 \ \le \ t_5 \ \le \ 0.6mm,$$

wherein "$t_4$" expresses the thickness of the reflection layer, "$t_3$" expresses the thickness of the second protective layer, "$t_2$" expresses the thickness of the recording layer, "$t_1$" expresses the thickness of the first protective layer, and "$t_5$" expresses the thickness of the light transmittance layer.

**15.** An optical recording medium according to Claim 12, including one or more of the recording layers.

**16.** An optical recording medium according to Claim 15, wherein
the optical recording medium includes a first information layer which has one of the recording layers, and a second information layer which has other one of the recording layers in this order, from a direction that the laser beam is irradiated, and a light transmittance of the first information layer is 40% or more with the wavelength of the laser beam used for recording or erasing.

**17.** An optical recording medium according to Claim 3, wherein the recording and the erasing are carried out by the reversible phase change between the amorphous phase and the crystalline phase in the recording layer, at a linear velocity of 14m/s or more.

**18.** An optical recording medium according to Claim 17, wherein the recording and the erasing are carried out by the reversible phase change between the amorphous phase and the crystalline phase in the recording layer, at a linear velocity of 28 m/s or more.

**19.** An optical recording medium according to any one of Claims 1 to 18, wherein a reflectance (Rg) at an unrecorded space part satisfies a relation of $12\% \le Rg \le 30\%$, when a laser beam having wavelength between 350 nm and 700 nm is irradiated.

**20.** An optical recording medium according to any one of Claims 1 to 19, wherein the optical recording medium has a degree of modulation (M) of 0.4 or more, when the recording is carried out at a linear velocity (V) one of between more than 3 m/s and 40 m/s or less and at wavelength of a laser beam used for recording or erasing of between 350 nm and 700 nm, and the degree of modulation (M) satisfies a relation of:

$$M=(Rg-Rb)/Rg,$$

where "M" expresses the degree of modulation, "Rb" expresses a reflectance at a recording mark of the optical recording medium, and "Rg" expresses a reflectance at an unrecorded space part of the optical recording medium.

**21.** An optical recording medium according to Claim 20, wherein the optical recording medium has the degree of modulation (M) of 0.4 or more, when the recording is carried out by an optical lens having NA of 0.60 or more.

22. An optical recording medium according to one of Claims 20 and 21, wherein the optical recording medium has the degree of modulation (M) of 0.6 or more.

23. An optical recording medium according to Claim 20, wherein the optical recording medium has the degree of modulation (M) of 0.4 or more, when the recording is carried out at any linear velocity (V) between 10 m/s and 35 m/s.

24. An optical recording medium according to Claim 23, wherein the optical recording medium has a jitter value of 10% or less, when the recording is carried out at any linear velocity (V) between 10 m/s and 35 m/s.

25. An optical recording medium according to any one of Claims 1 to 24 wherein the optical recording medium includes:

the substrate (7) ;
a first protective layer (1) ;
the recording layer (2);
a second protective layer (3);
a reflection layer (4); and
a surrounding protective layer,

wherein the first protective layer, the recording layer, the second protective layer, and the reflection layer are disposed on the substrate in this order, and the surrounding protective layer is disposed on a surface of the reflection layer.

26. A process for manufacturing an optical recording medium according to any one of Claims 1 to 25 **characterized in that** the process includes the steps of:

disposing a first protective layer, a recording layer, a second protective layer, a reflection layer in this order on a substrate, so as to manufacture an optical recording medium prior to initial crystallization;
irradiating a laser beam having a power density of 5 mW/$\mu$m$^2$ to 50 mW/$\mu$m$^2$ to the optical recording medium, while rotating the optical recording medium and radially moving the laser beam at a constant linear velocity for initial crystallization of 3 m/s to 18 m/s, so as to initially crystallize the optical recording medium.

27. A process for manufacturing an optical recording medium according to Claim 26, wherein the laser beam has the power density of 15 mW/$\mu$m$^2$ to 40 mW/$\mu$m$^2$, and the constant linear velocity for initial crystallization is 6 m/s to 14 m/s.

28. An optical recording process **characterized in that** the optical recording process includes the steps of:

forming a laser beam which reversibly phase changes between an amorphous phase and a crystalline phase in a recording layer which is disposed on a substrate of an optical recording medium according to any one of Claims 1 to 25, so as to have one of a single pulse and a plurality of pulses; and
irradiating the laser beam to the optical recording medium at a linear velocity (V) one of between more than 3 m/s and 40 m/s or less, and at a recording power (Pw) having a power density of 20 mW/$\mu$m$^2$ or more, so as to record in the recording layer.

29. An optical recording process according to Claim 28, wherein the linear velocity (V) is one of between 10 m/s and 35 m/s.

30. An optical recording process according to Claim 28 or 29, wherein the laser beam is irradiated, so that a ratio of an erasing power (Pe) to the recording power (Pw) satisfies a relation of:

$$0.10 \leq Pe/Pw \leq 0.65,$$

where "Pe" expresses the erasing power and "Pw" expresses the recording power.

31. An optical recording process according to Claim 30, wherein the laser beam is irradiated so as to have a ratio of an erasing power (Pe) to the recording power (Pw) which satisfies a relation of:

$$0.13 \leq Pe/Pw \leq 0.6,$$

where "Pe" expresses the erasing power and "Pw" expresses the recording power.

**Patentansprüche**

1. Optisches Aufzeichnungsmedium, umfassend:

   ein Substrat (7); und
   eine Aufzeichnungsschicht (2), die auf dem Substrat angeordnet ist, wobei die Aufzeichnung und Löschung durch eine reversible Phasenänderung zwischen einer amorphen Phase und einer kristallinen Phase in der Aufzeichnungsschicht durchgeführt werden,

   wobei die Aufzeichnungsschicht Ga und Sb enthält, der Gehalt an Sb 80 Atom-% bis 95 Atom-% relativ zum Gesamtgehalt von Ga und Sb in der Aufzeichnungsschicht ist, und
   wobei die Aufzeichnungsschicht ferner entweder Bi und Rh oder Zr und Mg als zusätzliche Elemente enthält.

2. Optisches Aufzeichnungsmedium nach Anspruch 1, wobei die Aufzeichnungsschicht, die Ga, Sb, Bi und Rh enthält, ferner ein Element ausgewählt aus Cu, B, N, Ge, Fe und Ir enthält.

3. Optisches Aufzeichnungsmedium nach Anspruch 1, wobei die Aufzeichnungsschicht, die Ga, Sb, Zr und Mg enthält, ferner ein Element ausgewählt aus Al, C, N , Se und Sn enthält.

4. Optisches Aufzeichnungsmedium nach irgendeinem der Ansprüche 1 bis 3,
   wobei der Gesamtgehalt von Ga und Sb in der Aufzeichnungsschicht 90 Atom-% oder mehr ist.

5. Optisches Aufzeichnungsmedium nach Anspruch 4, wobei der Gesamtgehalt an Ga und Sb in der Aufzeichnungsschicht 95 Atom-% oder mehr ist.

6. Optisches Aufzeichnungsmedium nach irgendeinem der Ansprüche 1 bis 5,
   wobei der Gehalt an Sb 85 Atom-% bis 95 Atom-% relativ zum Gesamtgehalt an Ga und Sb in der Aufzeichnungsschicht beträgt.

7. Optisches Aufzeichnungsmedium nach irgendeinem der Ansprüche 2 bis 6,
   wobei das optische Aufzeichnungsmedium:

   das Substrat (7);
   eine erste Schutzschicht (1);
   die Aufzeichnungsschicht (2);
   eine zweite Schutzschicht (3); und
   eine Reflexionsschicht (4) beinhaltet, wobei die erste Schutzschicht, die Aufzeichnungsschicht, die zweite Schutzschicht und die Reflexionsschicht auf dem Substrat in dieser Reihenfolge angeordnet sind und die Dicke der Reflexionsschicht die Beziehung: 0,10 λ oder mehr erfüllt, wenn "λ" die Wellenlänge des Laserstrahls, der zur Aufzeichnung oder Löschung verwendet wird, ausdrückt.

8. Optisches Aufzeichnungsmedium nach irgendeinem der Ansprüche 2 bis 7,
   wobei der Laserstrahl, der zum Aufzeichnen oder Löschen verwendet wird, eine Wellenlänge von 630 nm bis 700 nm aufweist.

9. Optisches Aufzeichnungsmedium nach Anspruch 8, wobei das optische Aufzeichnungsmedium:

   das Substrat (7);
   eine erste Schutzschicht (1);
   die Aufzeichnungsschicht (2);
   eine zweite Schutzschicht (3); und

eine Reflexionsschicht (4)

beinhaltet, wobei die erste Schutzschicht, die Aufzeichnungsschicht, die zweite Schutzschicht und die Reflexionsschicht auf dem Substrat in dieser Reihenfolge angeordnet sind und die Dicke der ersten Schutzschicht, die Dicke der Aufzeichnungsschicht, die Dicke der zweiten Schutzschicht und die Dicke der Reflexionsschicht jeweils die folgenden Beziehungen erfüllen, wenn "λ" die Wellenlänge des Laserstrahls, der zur Aufzeichnung oder Löschung verwendet wird, ausdrückt;

$$0{,}070 \; \lambda \leq t_1 \leq 0{,}16 \; \lambda$$

$$0{,}015 \; \lambda \leq t_2 \leq 0{,}032 \; \lambda$$

$$0{,}011 \; \lambda \leq t_3 \leq 0{,}040 \; \lambda$$

$$0{,}10 \; \lambda \leq t_4;$$

worin "$t_1$" die Dicke der ersten Schutzschicht ausdrückt; "$t_2$" die Dicke der Aufzeichnungsschicht ausdrückt, "$t_3$" die Dicke der zweiten Schutzschicht ausdrückt und "$t_4$" die Dicke der Reflexionsschicht ausdrückt.

10. Optisches Aufzeichnungsmedium nach einem der Ansprüche 8 und 9, wobei die Dicke der Aufzeichnungsschicht 5 nm bis 25 nm ist.

11. Optisches Aufzeichnungsmedium nach Anspruch 10, wobei die Dicke der Aufzeichnungsschicht 8 nm bis 20 nm beträgt.

12. Optisches Aufzeichnungsmedium nach irgendeinem der Ansprüche 2 bis 7, wobei der Laserstrahl, der zur Aufzeichnung oder Löschung verwendet wird, eine Wellenlänge von 350 nm bis 450 nm aufweist.

13. Optisches Aufzeichnungsmedium nach Anspruch 12, wobei das optische Aufzeichnungsmedium:

das Substrat (7);
eine erste Schutzschicht (1);
die Aufzeichnungsschicht (2);
eine zweite Schutzschciht (3); und
eine Reflexionsschicht (4)

beinhaltet, wobei die erste Schutzschicht, die Aufzeichnungsschicht, die zweite Schutzschicht und die Reflexionsschicht auf dem Substrat in dieser Reihenfolge angeordnet sind und die Dicke der ersten Schutzschicht, die Dicke der Aufzeichnungsschicht, die Dicke der zweiten Schutzschicht und die Dicke der Reflexionsschicht jeweils die folgenden Beziehungen erfüllen, wenn "λ" die Wellenlänge des Laserstrahls, der zur Aufzeichnung oder Löschung verwendet wird, ausdrückt

$$0{,}070 \; \lambda \leq t_1 \leq 0{,}5 \; \lambda$$

$$0{,}015 \; \lambda \leq t_2 \leq 0{,}05 \; \lambda$$

$$0{,}011 \, \lambda \leq t_3 \leq 0{,}055 \, \lambda$$

$$0{,}10 \, \lambda \leq t_4;$$

worin "$t_1$" die Dicke der ersten Schutzschicht ausdrückt, "$t_2$" die Dicke der Aufzeichnungsschicht ausdrückt, "$t_3$" die Dicke der zweiten Schutzschicht ausdrückt und "$t_4$" die Dicke der Reflexionsschicht ausdrückt.

14. Optisches Aufzeichnungsmedium nach Anspruch 12, wobei das optische Aufzeichnungsmedium:

    das Substrat (7);
    eine Reflexionsschicht (4);
    eine zweite Schutzschicht (3);
    die Aufzeichnungsschicht (2);
    eine erste Schutzschicht (1); und
    eine Lichtdurchlässigkeitsschicht (5)

beinhaltet, wobei die Reflexionsschicht, die zweite Schutzschicht, die Aufzeichnungsschicht, die erste Schutzschicht und die Lichtdurchlässigkeitsschicht auf dem Substrat in dieser Reihenfolge angeordnet sind und die Dicke der Reflexionsschicht, die Dicke der zweiten Schutzschicht, die Dicke der Aufzeichnungsschicht und die Dicke der ersten Schutzschicht und die Dicke der Lichtdurchlässigkeitsschicht die folgenden Beziehungen erfüllen, wenn "$\lambda$" die Wellenlänge des Laserstrahls, der zur Aufzeichnung oder Löschung verwendet wird, ausdrückt

$$0{,}10 \, \lambda \leq t_4 \leq 0{,}75 \, \lambda$$

$$0{,}011 \, \lambda \leq t_3 \leq 0{,}055 \, \lambda$$

$$0{,}015 \, \lambda \leq t_2 \leq 0{,}05 \, \lambda$$

$$0{,}070 \, \lambda \leq t_1 \leq 0{,}5 \, \lambda$$

$$0 \leq t_5 \leq 0{,}6 \, mm,$$

worin "$t_4$" die Dicke der Reflexionsschicht ausdrückt, "$t_3$" die Dicke der zweiten Schutzschicht ausdrückt, "$t_2$" die Dicke der Aufzeichnungsschicht ausdrückt, "$t_1$" die Dicke der ersten Schutzschicht ausdrückt und "$t_5$" die Dicke der Lichtdurchlässigkeitsschicht ausdrückt.

15. Optisches Aufzeichnungsmedium nach Anspruch 12, das eine oder mehrere der Aufzeichnungsschichten beinhaltet.

16. Optisches Aufzeichnungsmedium nach Anspruch 15, wobei das optische Aufzeichnungsmedium eine erste Informationsschicht, die eine der Aufzeichnungsschichten aufweist, und eine zweite Informationsschicht, die eine andere der Aufzeichnungsschichten aufweist, in dieser Reihenfolge von einer Richtung, aus welcher der Laserstrahl eingestrahlt wird, und die Lichtdurchlässigkeit der ersten Informationsschicht bei der Wellenlänge des Laserstrahls, der zur Aufzeichnung oder Löschung verwendet wird, 40% oder mehr beträgt.

17. Optisches Aufzeichnungsmedium nach Anspruch 3, wobei die Aufzeichnung und die Löschung durch die reversible Phasenänderung zwischen der amorphen Phase und der kristallinen Phase in der Aufzeichnungsschicht bei einer linearen Geschwindigkeit von 14 m/s oder mehr durchgeführt werden.

18. Optisches Aufzeichnungsmedium nach Anspruch 17, wobei die Aufzeichnung und die Löschung durch die reversible Phasenänderung zwischen der amorphen Phase und der kristallinen Phase in der Aufzeichnungsschicht bei einer linearen Geschwindigkeit von 28 m/s oder mehr durchgeführt werden.

19. Optisches Aufzeichnungsmedium nach irgendeinem der Ansprüche 1 bis 18,
wobei das Reflexionsvermögen (Rg) bei einem nicht aufgezeichneten Raumteil die Beziehung 12% ≤ Rg ≤ 30% erfüllt, wenn ein Laserstrahl mit einer Wellenlänge zwischen 350 nm und 700 nm eingestrahlt wird.

20. Optisches Aufzeichnungsmedium nach irgendeinem der Ansprüche 1 bis 19,
wobei das optische Aufzeichnungsmedium einen Modulationsgrad (M) von 0,4 oder mehr aufweist, wenn die Aufzeichnung bei einer linearen Geschwindigkeit (V) von einer aus mehr als 3 m/s und 40 m/s oder weniger und bei einer Wellenlänge des Laserstrahls, der zur Aufzeichnung oder Löschung verwendet wird, zwischen 350 nm und 700 nm durchgeführt wird, und der Modulationsgrad (M) die Beziehung :

$$M = (Rg-Rb)/Rg$$

erfüllt, worin "M" den Modulationsgrad ausdrückt, "Rb" ein Reflexionsvermögen bei einer Aufzeichnungsmarkierung des optischen Aufzeichnungsmediums ausdrückt und "Rg" ein Reflexionsvermögen bei einem nicht aufgezeichneten Raumteil des optischen Aufzeichnungsmediums ausdrückt.

21. Optisches Aufzeichnungsmedium nach Anspruch 20, wobei das optische Aufzeichnungsmedium einen Modulationsgrad (M) von 0,4 oder mehr aufweist, wenn die Aufzeichnung mit einer optischen Linse mit einer NA von 0,60 oder mehr durchgeführt wird.

22. Optisches Aufzeichnungsmedium nach einem der Ansprüche 20 und 21,
wobei das optische Aufzeichnungsmedium einen Modulationsgrad (M) von 0,6 oder mehr aufweist.

23. Optisches Aufzeichnungsmedium nach Anspruch 20, wobei das optische Aufzeichnungsmedium einen Modulationsgrad (M) von 0,4 oder mehr aufweist, wenn die Aufzeichnung bei irgendeiner linearen Geschwindigkeit (V) zwischen 10 m/s und 35 m/s durchgeführt wird.

24. Optisches Aufzeichnungsmedium nach Anspruch 23, wobei das optische Aufzeichnungsmedium einen Jitterwert von 10% oder weniger aufweist, wenn die Aufzeichnung bei irgendeiner linearen Geschwindigkeit (V) zwischen 10 m/s und 35 m/s durchgeführt wird.

25. Optisches Aufzeichnungsmedium nach irgendeinem der Ansprüche 1 bis 24,
wobei das optische Aufzeichnungsmedium:

  das Substrat (7);
  eine erste Schutzschicht (1);
  die Aufzeichnungsschicht (2);
  eine zweite Schutzschicht (3);
  eine Reflexionsschicht (4); und
  eine umgebende Schutzschicht

beinhaltet, wobei die erste Schutzschicht, die Aufzeichnungsschicht, die zweite Schutzschicht und die Reflexionsschicht auf dem Substrat in dieser Reihenfolge angeordnet sind und die umgebende Schutzschicht auf einer Oberfläche der Reflexionsschicht angeordnet ist.

26. Verfahren zur Herstellung eines optischen Aufzeichnungsmediums nach irgendeinem der Ansprüche 1 bis 25, **dadurch gekennzeichnet, dass** das Verfahren die folgenden Schritte beinhaltet:

  Anordnen einer ersten Schutzschicht, einer Aufzeichnungsschicht, einer zweiten Schutzschicht, einer Reflexionsschicht in dieser Reihenfolge auf einem Substrat, um ein optisches Aufzeichnungsmedium vor der anfänglichen Kristallisation herzustellen;

Bestrahlen des optischen Aufzeichnungsmediums mit einem Laserstrahl mit einer Energiedichte von 5 mW/$\mu$m² bis 50 mW/$\mu$m², während das optische Aufzeichnungsmedium rotiert wird und der Laserstrahl mit einer konstanten Lineargeschwindigkeit für die anfängliche Kristallisation von 3 m/s bis 18 m/s radial bewegt wird, um das optische Aufzeichnungsmedium anfänglich zu kristallisieren.

**27.** Verfahren zur Herstellung eines optischen Aufzeichnungsmediums nach Anspruch 26, wobei der Laserstrahl eine Energiedichte von 15 mW/$\mu$m² bis 40 mW/$\mu$m² aufweist und die konstante Lineargeschwindigkeit für die anfängliche Kristallisation 6 m/s bis 14 m/s beträgt.

**28.** Optisches Aufzeichnungsverfahren, **dadurch gekennzeichnet, dass** das optische Aufzeichnungsverfahren die folgenden Schritte beinhaltet:

Erzeugen eines Laserstrahls, der reversibel eine Phasenänderung zwischen einer amorphen Phase und einer kristallinen Phase in einer Aufzeichnungsschicht ausführt, die auf einem Substrat von einem optischen Aufzeichnungsmedium nach irgendeinem der Ansprüche 1 bis 25 angeordnet ist, um einen aus einem Einzelpuls und einer Vielzahl von Pulsen aufzuweisen; und

Bestrahlen des optischen Aufzeichnungsmediums mit dem Laserstrahl mit einer linearen Geschwindigkeit (V) von einer aus mehr als 3 m/s und 40 m/s oder weniger und bei einer Aufzeichnungsenergie (Pw) mit einer Energiedichte von 20 mW/$\mu$m² oder mehr, um in der Aufzeichnungsschicht aufzuzeichnen.

**29.** Optisches Aufzeichnungsverfahren nach Anspruch 28, wobei die lineare Geschwindigkeit (V) eine von zwischen 10 m/s und 35 m/s ist.

**30.** Optisches Aufzeichnungsverfahren nach Anspruch 28 oder 29, wobei der Laserstrahl eingestrahlt wird, so dass das Verhältnis der Löschenergie (Pe) zur Aufzeichnungsenergie (Pw) die Beziehung

$$0{,}10 \le Pe/Pw \le 0{,}65$$

erfüllt, worin "Pe" die Löschenergie ausdrückt und "Pw" die Aufzeichnungsenergie ausdrückt.

**31.** Optisches Aufzeichnungsverfahren nach Anspruch 30, wobei der Laserstrahl eingestrahlt wird, um ein Verhältnis der Löschenergie (Pe) zur Aufzeichnungsenergie (Pw) zu erhalten, das die Beziehung

$$0{,}13 \le Pe/Pw \le 0{,}6$$

erfüllt, worin "Pe" die Löschenergie ausdrückt und "Pw" die Aufzeichnungsenergie ausdrückt.

**Revendications**

**1.** Support d'enregistrement optique comprenant :

un substrat (7) ; et
une couche d'enregistrement (2) disposée sur le substrat, l'enregistrement et l'effacement étant réalisés par un changement de phase réversible entre une phase amorphe et une phase cristalline dans la couche d'enregistrement,

dans lequel la couche d'enregistrement contient Ga et Sb, le contenu de Sb étant de 80 % par atome à 95 % par atome par rapport au contenu total de Ga et Sb dans la couche d'enregistrement, et
dans lequel la couche d'enregistrement contient en outre soit Bi et Rh soit Zr et Mg comme des éléments supplémentaires.

**2.** Support d'enregistrement optique selon la revendication 1, dans lequel la couche d'enregistrement contenant Ga, Sb, Bi et Rh contient en outre un élément sélectionné parmi le groupe consistant en Cu, B, N, Ge, Fe et Ir.

**3.** Support d'enregistrement optique selon la revendication 1, dans lequel la couche d'enregistrement contenant Ga, Sb, Zr et Mg contient en outre un élément sélectionné parmi le groupe consistant en A1, C, N, Se et Sn.

**4.** Support d'enregistrement optique selon l'une quelconque des revendications 1 à 3, dans lequel le contenu total de Ga et Sb est 90 % en atome ou plus dans la couche d'enregistrement.

**5.** Support d'enregistrement optique selon la revendication 4, dans lequel le contenu total de Ga et Sb dans la couche d'enregistrement est de 95 % par atome ou plus.

**6.** Support d'enregistrement optique selon l'une quelconque des revendications 1 à 5, dans lequel le contenu de Sb est de 85 % d'atome à 95 % d'atome par rapport au contenu total de Ga et Sb dans la couche d'enregistrement.

**7.** Support d'enregistrement optique selon l'une quelconque des revendications 2 à 6, dans lequel le support d'enregistrement optique comprend :

 le substrat (7) ;
 une première couche de protection (1) ;
 la couche d'enregistrement (2) ;
 une deuxième couche de protection (3) ; et
 une couche de réflexion (4),

dans lequel la première couche de protection, la couche d'enregistrement, la deuxième couche de protection et la couche de réflexion sont disposées sur le substrat dans cet ordre et une épaisseur de la couche de réflexion satisfait une relation de : 0,10 λ ou plus, où le λ exprime la longueur d'onde du faisceau laser utilisé pour l'enregistrement ou l'effacement.

**8.** Support d'enregistrement optique selon l'une quelconque des revendications 2 à 7, dans lequel le faisceau laser utilisé pour l'enregistrement ou l'effacement a une longueur d'onde de 630 nm à 700 nm.

**9.** Support d'enregistrement optique selon la revendication 8, dans lequel le support d'enregistrement optique comprend :

 le substrat (7) ;
 une première couche de protection (1) ;
 la couche d'enregistrement (2) ;
 une deuxième couche de protection (3) ; et
 une couche de réflexion (4),

dans lequel la première couche de protection, la couche d'enregistrement, la deuxième couche de protection et la couche de réflexion sont disposées sur le substrat dans cet ordre et chacune de l'épaisseur de la première couche de protection, de l'épaisseur de la couche d'enregistrement, de l'épaisseur de la deuxième couche de protection et de l'épaisseur de la couche de réflexion satisfait les relations suivantes, lorsque « λ » exprime la longueur d'onde du faisceau laser utilisé pour l'enregistrement ou l'effacement ;

$$0,070\lambda \leq t_1 \leq 0,16\lambda$$

$$0,015\lambda \leq t_2 \leq 0,032\lambda$$

$$0,011\lambda \leq t_3 \leq 0,040\lambda$$

$$0,10\lambda \leq t_4 \; ;$$

où « $t_1$ » exprime l'épaisseur de la première couche de protection, « $t_2$ » exprime l'épaisseur de la couche d'enregistrement, « $t_3$ » exprime l'épaisseur de la deuxième couche de protection et « $t_4$ » exprime l'épaisseur de la couche de réflexion.

**10.** Support d'enregistrement optique selon l'une des revendications 8 et 9, dans lequel l'épaisseur de la couche d'enregistrement est de 5 nm à 25 nm.

**11.** Support d'enregistrement optique selon la revendication 10, dans lequel l'épaisseur de la couche d'enregistrement est de 8 nm à 20 nm.

**12.** Support d'enregistrement optique selon l'une quelconque des revendications 2 à 7, dans lequel le faisceau laser utilisé pour l'enregistrement ou l'effacement a une longueur d'onde de 350 nm à 450 nm.

**13.** Support d'enregistrement optique selon la revendication 12, dans lequel le support d'enregistrement optique comprend :

    le substrat (7) ;
    une première couche de protection (1) ;
    la couche d'enregistrement (2) ;
    une deuxième couche de protection (3) ; et
    la couche de réflexion (4),

dans lequel la première couche de protection, la couche d'enregistrement, la deuxième couche de protection et la couche de réflexion sont disposées sur le substrat dans cet ordre et chacune de l'épaisseur de la première couche de protection, de l'épaisseur de la couche d'enregistrement, de l'épaisseur de la deuxième couche de protection et de l'épaisseur de la couche de réflexion satisfait les relations suivantes, lorsque « $\lambda$ » exprime la longueur d'onde du faisceau laser utilisé pour l'enregistrement ou l'effacement ;

$$0,070\lambda \leq t_1 \leq 0,5\lambda$$

$$0,015\lambda \leq t_2 \leq 0,05\lambda$$

$$0,011\lambda \leq t_3 \leq 0,055\lambda$$

$$0,10\lambda \leq t_4 \; ;$$

dans lequel « $t_1$ » exprime l'épaisseur de la première couche de protection, « $t_2$ » exprime l'épaisseur de la couche d'enregistrement, « $t_3$ » exprime l'épaisseur de la deuxième couche de protection et « $t_4$ » exprime l'épaisseur de la couche de réflexion.

**14.** Support d'enregistrement optique selon la revendication 12, dans lequel le support d'enregistrement optique comprend :

    le substrat (7) ;
    une couche de réflexion (4) ;
    une deuxième couche de protection (3) ;

la couche d'enregistrement (2) ;
une première couche de protection (1) ; et
une couche de transmission de la lumière (5),

dans lequel la couche de réflexion, la deuxième couche de protection, la couche d'enregistrement, la première couche de protection et la couche de transmission de la lumière sont disposées sur le substrat dans cet ordre, et chacune de l'épaisseur de la couche de réflexion, d'une épaisseur de la deuxième couche de protection, d'une épaisseur de la couche d'enregistrement et d'une épaisseur de la première couche de protection et une épaisseur de la couche de transmission de la lumière satisfait les relations suivantes, lorsque « λ » exprime la longueur d'onde du faisceau laser utilisé pour l'enregistrement ou l'effacement ;

$$0,10\lambda \leq t_4 \leq 0,75\lambda$$

$$0,011\lambda \leq t_3 \leq 0,055\lambda$$

$$0,015\lambda \leq t_2 \leq 0,05\lambda$$

$$0,070\lambda \leq t_1 \leq 0,5\lambda$$

$$0 \leq t_5 \leq 0,6mm,$$

dans lequel « $t_4$ » exprime l'épaisseur de la couche de réflexion, « $t_3$ » exprime l'épaisseur de la deuxième couche de protection, « $t_2$ » exprime l'épaisseur de la couche d'enregistrement, « $t_1$ » exprime l'épaisseur de la première couche de protection et « $t_5$ » exprime l'épaisseur de la couche de transmission de la lumière.

**15.** Support d'enregistrement optique selon la revendication 12, comprenant en outre une ou plusieurs des couches d'enregistrement.

**16.** Support d'enregistrement optique selon la revendication 15, dans lequel le support d'enregistrement optique comprend une première couche d'information qui comporte une des couches d'enregistrement et une deuxième couche d'information qui comporte l'autre des couches d'enregistrement dans cet ordre, depuis une direction dans laquelle le faisceau laser est irradié et la transmission de la lumière de la première couche d'information est 40 % ou plus avec la longueur d'onde du faisceau laser qui est utilisé pour l'enregistrement ou l'effacement.

**17.** Support d'enregistrement optique selon la revendication 3, dans lequel l'enregistrement et l'effacement sont réalisés par le changement de phase réversible entre la phase amorphe et la phase cristalline dans la couche d'enregistrement à une vitesse linéaire de 14 m/s ou plus.

**18.** Support d'enregistrement optique selon la revendication 17, dans lequel l'enregistrement et l'effacement sont réalisés par le changement de phase réversible entre la phase amorphe et la phase cristalline dans la couche d'enregistrement à une vitesse linéaire de 28 m/s ou plus.

**19.** Support d'enregistrement optique selon l'une quelconque des revendications 1 à 18, dans lequel un facteur de réflexion (Rg) au niveau d'une partie d'espace non enregistré satisfait une relation de 12 % ≤ Rg ≤ 30 %, lorsqu'un faisceau laser ayant une longueur d'onde entre 350 nm et 700 nm est irradié.

**20.** Support d'enregistrement optique selon l'une quelconque des revendications 1 à 19, dans lequel le support d'enregistrement optique a un degré de modulation (M) de 0,4 ou plus, lorsque l'enregistrement est réalisé à une vitesse linéaire (V) comprise entre plus de 3 m/s et 40 m/s ou moins et à une longueur d'onde d'un faisceau laser utilisé pour l'enregistrement ou l'effacement comprise entre 350 nm et 700 nm et le degré de modulation (M) satisfait la

relation de :

$$M=(Rg-Rb)/Rg,$$

où « M » exprime le degré de modulation, « Rb » exprime le facteur de réflexion au niveau d'une marque d'enregistrement du support d'enregistrement optique et « Rg » exprime le facteur de réflexion au niveau d'une partie d'espace non enregistré du support d'enregistrement optique.

21. Support d'enregistrement optique selon la revendication 20, dans lequel le support d'enregistrement optique a un degré de modulation (M) de 0,4 ou plus, lorsque l'enregistrement est réalisé par une lentille optique ayant une NA de 0,60 ou plus.

22. Support d'enregistrement optique selon l'une des revendications 20 et 21, dans lequel le support d'enregistrement optique a un degré de modulation (M) de 0,6 ou plus.

23. Support d'enregistrement optique selon la revendication 20, dans lequel le support d'enregistrement optique a un degré de modulation (M) de 0,4 ou plus, lorsque l'enregistrement est réalisé à une vitesse linéaire (V) comprise entre 10 m/s et 35 m/s.

24. Support d'enregistrement optique selon la revendication 23, dans lequel le support d'enregistrement optique a une valeur de sautillement de 10 % ou moins, lorsque l'enregistrement est réalisé à une vitesse linéaire quelconque (V) entre 10 m/s et 35 m/s.

25. Support d'enregistrement optique selon l'une quelconque des revendications 1 à 24, dans lequel le support d'enregistrement optique comprend :

le substrat (7) ;
une première couche de protection (1) ;
la couche d'enregistrement (2) ;
une deuxième couche de protection (3) ;
une couche de réflexion (4) ; et
une couche de protection extérieure,

dans lequel la première couche de protection, la couche d'enregistrement, la deuxième couche de protection et la couche de réflexion sont disposées sur le substrat dans cet ordre et la couche de protection extérieure est disposée sur une surface de la couche de réflexion.

26. Processus de fabrication d'un support d'enregistrement optique selon l'une quelconque des revendications 1 à 25, **caractérisé en ce que** le processus comprend les étapes consistant à :

disposer une première couche de protection, une couche d'enregistrement, une deuxième couche de protection, une couche de réflexion dans cet ordre sur un substrat, de telle manière à fabriquer un support d'enregistrement optique avant la cristallisation initiale ;
irradier un faisceau laser ayant une densité de puissance de 5 mW/$\mu$m$^2$ à 50 mW/$\mu$m$^2$ sur le support d'enregistrement optique, tout en faisant tourner le support d'enregistrement optique et déplacer radialement le faisceau laser à une vitesse linéaire constante pour la cristallisation initiale de 3 m/s à 18 m/s, de telle manière à cristalliser le support d'enregistrement optique.

27. Processus de fabrication d'un support d'enregistrement optique selon la revendication 26, dans lequel le faisceau laser a la densité de puissance de 15 mW/$\mu$m$^2$ à 40 mW/$\mu$m$^2$ et la vitesse linéaire constante pour la cristallisation initiale est de 6 m/s à 14 m/s.

28. Processus d'enregistrement optique **caractérisé en ce que** le processus d'enregistrement optique comprend les étapes consistant à :

former un faisceau laser qui change de phase de manière réversible entre une phase amorphe et une phase cristalline dans une couche d'enregistrement qui est disposée sur un substrat d'un support d'enregistrement optique selon l'une quelconque des revendications 1 à 25, de telle manière à avoir l'une d'une impulsion unique et d'une pluralité d'impulsions ; et

irradier le faisceau laser sur le support d'enregistrement optique à une vitesse linéaire (V) comprise entre plus de 3 m/s et 40 m/s ou moins et à une puissance d'enregistrement (Pw) ayant une densité de puissance de 20 mW/$\mu$m$^2$ ou plus, de telle manière à enregistrer dans la couche d'enregistrement.

29. Processus d'enregistrement optique selon la revendication 28, dans lequel la vitesse linéaire (V) est comprise entre 10 m/s et 35 m/s.

30. Processus d'enregistrement optique selon la revendication 28 ou 29, dans lequel le faisceau laser est irradié, de telle sorte qu'un rapport de puissance d'effacement (Pe) par rapport à la puissance d'enregistrement (Pw) satisfait une relation de :

$$0,10 \leq Pe/Pw \leq 0,65,$$

où « Pe » exprime la puissance d'effacement et « Pw » exprime la puissance d'enregistrement.

31. Processus d'enregistrement optique selon la revendication 30, dans lequel le faisceau laser est irradié de telle manière à avoir un rapport d'une puissance d'effacement (Pe) à la puissance d'enregistrement (Pw) qui satisfait la relation de :

$$0,13 \leq Pe/Pw \leq 0,6,$$

où « Pe » exprime la puissance d'effacement et « Pw » exprime la puissance d'enregistrement.

# FIG. 1

Laser beam

# FIG. 2

Laser beam

# FIG. 3

Laser beam

FIG. 4

EP 1 566 800 B1

## FIG. 5

42

# FIG. 6

**EP 1 566 800 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3231889 A
- JP 4191089 A
- JP 4232779 A
- JP 4267192 A
- JP 5345478 A
- JP 2000322740 A
- US 4818666 A
- US 5072423 A
- JP 2001039031 A
- EP 1260973 A

**Non-patent literature cited in the description**

- Phase-change optical data storage in GaSb. *Applied optics,* November 1987, vol. 26 (22115
- *Appl. Phys. Lett.,* 22 June 1992, vol. 60 (25), 3123-3125